# EUROPEAN PATENT SPECIFICATION

(11) **EP 3 569 628 B1**
(45) Date of publication and mention of the grant of the patent: **11.08.2021**
(21) Application number: 18738684.2
(22) Date of filing: 09.01.2018
(51) Int. Cl.: C08G 59/32, C08G 59/42, C09J 163/00, C08G 59/30, C09D 163/00, H01L 23/29, H05K 1/03, C08G 59/68

(54) **EPOXY RESIN COMPOSITION**
EPOXIDHARZZUSAMMENSETZUNG
COMPOSITION DE RÉSINE ÉPOXYDE

(30) Priority: 10.01.2017 JP 2017002214
(43) Date of publication of application: 20.11.2019
(73) Proprietor: Sumitomo Seika Chemicals Co., Ltd., Kako-gun, Hyogo 675-0145 (JP)
(72) Inventor: FUKUDA, Noriaki, Kako-gun Hyogo 675-0145 (JP); HARISAKI, Ryota, Kako-gun Hyogo 675-0145 (JP); YAMAMOTO, Katsumasa, Kako-gun Hyogo 675-0145 (JP)
(74) Representative: Mewburn Ellis LLP
(86) International application number: PCT/JP2018/000200
(87) International publication number: WO 2018/131569

(56) References cited:
- EP-A1- 1 765 265
- WO-A1-2015/041325
- WO-A1-2017/010401
- WO-A1-2017/086368
- JP-A- 2003 519 705
- JP-A- 2004 527 602
- JP-A- 2008 505 945
- JP-A- 2012 001 668
- JP-A- 2016 117 904
- JP-A- 2017 019 983
- US-A1- 2016 255 718

## Description

### Technical Field

The present invention relates to an epoxy resin composition, a method for producing the same, use of the composition, etc.

### Background Art

The frequency of transmission signals has recently increased along with an increase in the performance of electronic devices and a reduction in the weight and size thereof. In accordance with the increased frequency, materials used in printed circuit boards and semiconductor sealing materials are strongly required to have a lower dielectric constant in the high frequency region. In this field, thermosetting resins, such as epoxy resins, are widely used as substrate materials or sealing materials. PTL 1 discloses that an epoxy resin composition comprising a specific epoxy resin and a specific active ester compound has high adhesion and low dielectric tangent characteristics.

### Citation List

### Patent Literature

PTL 1: JP2016-117904A
PTL 2: JP2004-277460A
PTL 3: GB1123960B

### Summary of Invention

### Technical Problem

However, the dielectric characteristics of a cured product of the epoxy resin composition of PTL 1 are improved, but are still not sufficient.

Accordingly, an object of the present invention is to provide an epoxy resin composition that has excellent electric characteristics (particularly low dielectric tangent) when cured, and that can achieve high adhesive strength to metal.

### Solution to Problem

As a result of extensive research to solve the above problem, the present inventors found that an epoxy resin composition comprising an active ester compound and a specific epoxy resin containing a silicon atom has excellent low dielectric characteristics. The present invention has been completed upon further studies based on this finding.

The present invention includes the main subjects shown below.
Item 1. An epoxy resin composition comprising an epoxy resin and an active ester compound, the epoxy resin being represented by the formula (1): 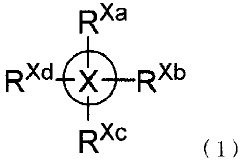
   wherein X ring is a saturated hydrocarbon ring or an unsaturated hydrocarbon ring, or rings having a structure in which 2 to 6 saturated hydrocarbon rings and/or unsaturated hydrocarbon rings are condensed, or in which 2 saturated hydrocarbon rings and/or unsaturated hydrocarbon rings are connected;
   R^{Xa}, R^{Xb}, R^{Xc}, and R^{Xd} are the same or different, and each is a hydrogen atom, a lower alkyl group, a lower alkoxy group, a lower alkenyl group, a halogen atom, or a group represented by the formula (3):

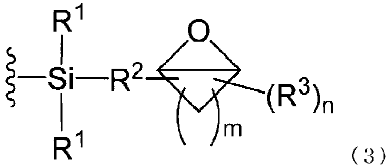

   wherein R¹ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
   R² is a C₁₋₁₈ alkylene group, wherein one or more carbon atoms of this group other than a carbon atom directly bonded to a silicon atom may be replaced by at least one atom selected from the group consisting of an oxygen atom and a nitrogen atom;
   R³ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
   m is an integer of 0 to 6; and
   n is an integer of 0 to 3;
   provided that at least one of R^{Xa}, R^{Xb}, R^{Xc}, and R^{Xd} is a group represented by the formula (3); and
   one or more hydrogen atoms bonded to one or more carbon atoms that constitute the hydrocarbon ring constituting the X ring, and that are not bonded to R^{Xa}, R^{Xb}, R^{Xc}, or R^{Xd}, may be replaced by a lower alkyl group, a lower alkoxy group, a lower alkenyl group, or a halogen atom.
Item 2. The epoxy resin composition according to Item 1, wherein the rings having a structure in which 2 saturated hydrocarbon rings and/or unsaturated hydrocarbon rings are connected are rings represented by the formula (2): 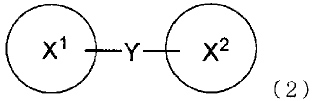
   wherein X¹ ring and X² ring are the same or different, and each is a saturated hydrocarbon ring or an unsaturated hydrocarbon ring; and
   Y is a bond, a C₁₋₆ alkylene group that may be substituted with a C₁₋₄ alkyl group, an oxygen atom (-O-), a sulfur atom (-S-), -SO-, or -SO₂-.
Item 3. The epoxy resin composition according to Item 1 or 2, wherein the saturated hydrocarbon ring is a C₄₋₈ saturated hydrocarbon ring, and the unsaturated hydrocarbon ring is a C₄₋₈ unsaturated hydrocarbon ring.
Item 4. The epoxy resin composition according to Item 1, wherein the composition comprises an active ester compound and at least one epoxy resin selected from the group consisting of: an epoxy resin represented by the formula (1-iia): 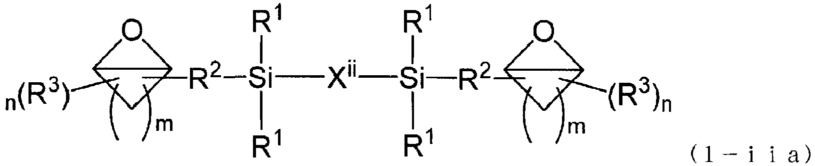 wherein Xⁱⁱ is a divalent group obtained by removing two hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a divalent group represented by the formula (2^{g}-iia): 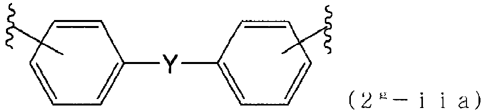
   wherein Y is a bond, a C₁₋₆ alkylene group that may be substituted with a C₁₋₄ alkyl group, an oxygen atom (-O-), a sulfur atom (-S-), -SO-, or -SO₂-;
   R¹ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
   R² is the same or different, and is a C₁₋₁₈ alkylene group, wherein one or more carbon atoms of this group other than a carbon atom directly bonded to a silicon atom may be replaced by at least one atom selected from the group consisting of an oxygen atom and a nitrogen atom;
   R³ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
   m is an integer of 0 to 6; and
   n is an integer of 0 to 3; and
   an epoxy resin represented by the formula (1-iiia): 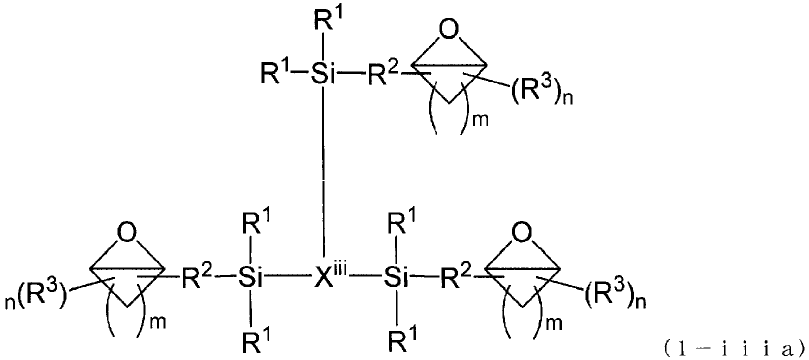
   wherein Xⁱⁱⁱ is a trivalent group obtained by removing three hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a trivalent group represented by the formula (2^{g}-iiia): 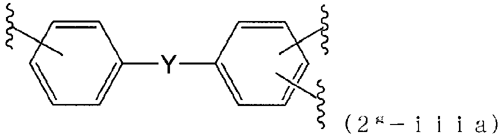
   wherein Y is as defined above; and
   R¹, R², R³, m, and n are as defined above.
Item 5. The epoxy resin composition according to any one of Items 1 to 4, wherein the active ester compound is a compound having two or more ester groups per molecule.
Item 6. The epoxy resin composition according to any one of Items 1 to 4, wherein the active ester compound is a condensate of at least one member selected from the group consisting of a carboxylic acid compound and a thiocarboxylic acid compound, and at least one member selected from the group consisting of a hydroxy compound and a thiol compound.
Item 7. The epoxy resin composition according to any one of Items 1 to 4, wherein the active ester compound is an ester compound containing a dicyclopentadienyl diphenol structure.
Item 8. A cured product of the epoxy resin composition according to any one of Items 1 to 7.
Item 9. A semiconductor sealing material, a liquid sealing material, a potting material, a sealing material, an interlayer insulation film, an adhesive layer, a coverlay film, an electromagnetic shielding film, a printed circuit board material, or a composite material, each of which uses the epoxy resin composition according to any one of Items 1 to 7 or the cured product according to Item 8.
Item 10. The epoxy resin composition according to any one of Items 1 to 7 or the cured product according to Item 8 for use in a semiconductor sealing material, a liquid sealing material, a potting material, a sealing material, an interlayer insulation film, an adhesive layer, a coverlay film, an electromagnetic shielding film, a printed circuit board material, or a composite material.
Item 11. Use of the epoxy resin composition according to any one of Items 1 to 7 or the cured product according to Item 8 for producing a semiconductor sealing material, a liquid sealing material, a potting material, a sealing material, an interlayer insulation film, an adhesive layer, a coverlay film, an electromagnetic shielding film, a printed circuit board material, or a composite material.

### Advantageous Effects of Invention

A cured product of the epoxy resin composition of the present invention has good electric characteristics and high adhesive strength to metal. Therefore, the epoxy resin composition of the present invention can be suitably used for various applications, such as semiconductor sealing materials, liquid sealing materials, potting materials, sealing materials, interlayer insulation films, adhesive layers, coverlay films, electromagnetic shielding films, printed circuit board materials, and composite materials.

### Description of Embodiments

Embodiments of the present invention are described in more detail below.

The epoxy resin composition contained in the present invention comprises an epoxy resin and an active ester compound, the epoxy resin being represented by the formula (1):

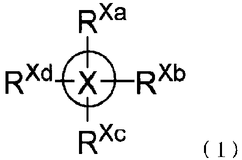

In the formula (1), R^{Xa}, R^{Xb}, R^{Xc}, and R^{Xd} are the same or different, and each is a hydrogen atom, a lower alkyl group, a lower alkoxy group, a lower alkenyl group, a halogen atom, or a group represented by the formula (3): 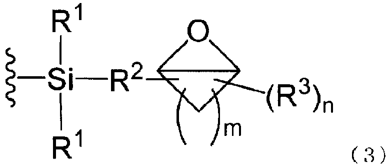 (hereinafter also referred to as the "group of the formula (3)"). Hereinafter, a lower alkyl group, a lower alkoxy group, and a lower alkenyl group are also collectively referred to as "lower carbon substituents." In the present invention, among the lower carbon substituents, a lower alkyl group or a lower alkoxy group is more preferable.

However, at least one of R^{Xa}, R^{Xb}, R^{Xc}, and R^{Xd} is a group of the formula (3). In other words, three of R^{Xa}, R^{Xb}, R^{Xc}, and R^{Xd} are hydrogen atoms, halogen atoms, or lower carbon substituents, and the other one is a group of the formula (3); two of them are hydrogen atoms, halogen atoms, or lower carbon substituents, and the other two are groups of the formula (3); one of them is a hydrogen atom, a halogen atom, or a lower carbon substituent, and the other three are groups of the formula (3); or all of them are groups of the formula (3). More specifically, for example, R^{Xa} R^{Xb}, R^{Xc}, and R^{Xd} may be as follows:
(i) R^{Xa}, R^{Xb}, and R^{Xc} are hydrogen atoms, halogen atoms, or lower carbon substituents, and R^{Xd} is a group of the formula (3);
(ii) R^{Xa} and R^{Xb} are hydrogen atoms, halogen atoms, or lower carbon substituents, and R^{Xc} and R^{Xd} are groups of the formula (3) ;
(iii) R^{Xa} is a hydrogen atom, a halogen atom, or a lower carbon substituent, and R^{Xb} R^{Xc}, and R^{Xd} are groups of the formula (3) ; or
(iv) all of R^{Xa}, R^{Xb}, R^{Xc}, and R^{Xd} are groups of the formula (3) .
Of R^{Xa} R^{Xb}, R^{Xc}, and R^{Xd}, one or more members that are not groups of the formula (3) are more preferably hydrogen atoms or lower carbon substituents.

In the formula (1), R^{Xa}, R^{Xb}, R^{Xc}, and R^{Xd} may be the same or different. Therefore, (i) when R^{Xa}, R^{Xb}, and R^{Xc} are hydrogen atoms, halogen atoms, or lower carbon substituents, and when R^{Xd} is a group of the formula (3), R^{Xa}, R^{Xb}, and R^{Xc} may be the same or different. (ii) When R^{Xa} and R^{Xb} are hydrogen atoms, halogen atoms, or lower carbon substituents, and when R^{Xc} and R^{Xd} are groups of the formula (3), R^{Xa} and R^{Xb} may be the same or different, and R^{Xc} and R^{Xd} may also be the same or different. (iii) When R^{Xa} is a hydrogen atom, a halogen atom, or a lower carbon substituent, and when R^{Xb}, R^{Xc}, and R^{Xd} are groups of the formula (3), R^{Xb}, R^{Xc}, and R^{Xd} may be the same or different. (iv) When all of R^{Xa}, R^{Xb}, R^{Xc}, and R^{Xd} are groups of the formula (3), R^{Xa}, R^{Xb}, R^{Xc}, and R^{Xd} may be the same or different. In any of these cases, the groups of the formula (3) are preferably the same.

Moreover, when two or three of R^{Xa} R^{Xb}, R^{Xc}, and R^{Xd} are halogen atoms or lower carbon substituents, these halogen atoms or lower carbon substituents may also be the same or different. In this case, two or three of R^{Xa}, R^{Xb}, R^{Xc}, and R^{Xd} are more preferably the same lower carbon substituents.

In the present specification, the lower carbon substituent refers to a lower alkyl group, a lower alkoxy group, or a lower alkenyl group. The term "lower" used herein means 1 to 6 (1, 2, 3, 4, 5, or 6) carbon atoms. Of the lower carbon substituents, a lower alkyl group or a lower alkoxy group is preferable. Specifically, preferable examples of lower alkyl groups include a methyl group, an ethyl group, an n-propyl group, an isopropyl group, an n-butyl group, an isobutyl group, and the like. Preferable examples of lower alkoxy groups include a methoxy group, an ethoxy group, a propoxy group, an isopropoxy group, a butoxy group, an isobutoxy group, and the like.

Moreover, in the present specification, the halogen atom is a fluorine atom, a chlorine atom, a bromine atom, or an iodine atom; preferably a fluorine atom, a chlorine atom, or a bromine atom; and more preferably a fluorine atom or a bromine atom.

In the formula (1), X ring is a saturated hydrocarbon ring or an unsaturated hydrocarbon ring, or rings having a structure in which 2 to 6 saturated hydrocarbon rings and/or unsaturated hydrocarbon rings are condensed, or in which 2 saturated hydrocarbon rings and/or unsaturated hydrocarbon rings are connected. In the present specification, the saturated hydrocarbon ring is, for example, preferably a C₄₋₈ (4, 5, 6, 7, or 8) saturated hydrocarbon ring, and particularly preferably a cyclopentane ring, a cyclohexane ring, or the like. In the present specification, the unsaturated hydrocarbon ring is, for example, preferably a C₄₋₈ (4, 5, 6, 7, or 8) unsaturated hydrocarbon ring, and particularly preferably a benzene ring or the like. In the present specification, the rings having a structure in which 2 to 6 saturated hydrocarbon rings and/or unsaturated hydrocarbon rings are condensed are preferably 2, 3, or 4 condensed saturated hydrocarbon rings and/or unsaturated hydrocarbon rings, and more preferably 2 or 3 condensed saturated hydrocarbon rings and/or unsaturated hydrocarbon rings. More specific examples include a decahydronaphthalene ring, an adamantane ring, a naphthalene ring, a phenanthrene ring, an anthracene ring, a pyrene ring, a triphenylene ring, a tetralin ring, 1,2,3,4,5,6,7,8-octahydronaphthalene ring, a norbornene ring, and the like.

In the present specification, a saturated hydrocarbon ring or an unsaturated hydrocarbon ring, or rings having a structure in which 2 to 6 saturated hydrocarbon rings and/or unsaturated hydrocarbon rings are condensed, are also collectively referred to as "hydrocarbon rings."

The rings having a structure in which 2 saturated hydrocarbon rings and/or unsaturated hydrocarbon rings are connected are preferably rings represented by the formula (2):

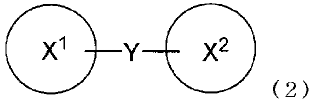

In the formula (2), X¹ ring and X² ring are the same or different, and each is a saturated hydrocarbon ring or an unsaturated hydrocarbon ring. That is, the X¹ ring and X² ring are both saturated hydrocarbon rings or unsaturated hydrocarbon rings; or one of them is a saturated hydrocarbon ring, and the other is an unsaturated hydrocarbon ring. It is preferable that the X¹ ring and the X² ring be both saturated hydrocarbon rings or unsaturated hydrocarbon rings. For example, it is preferable that the X¹ ring and the X² ring be both benzene rings or cyclohexane rings, or that one of them be a benzene ring and the other be a cyclohexane ring; and it is more preferable that both of them be benzene rings.

Moreover, Y is a bond, a C₁₋₆ alkylene group that may be substituted with a C₁₋₄ alkyl group, an oxygen atom (-O-), a sulfur atom (-S-), -SO-, or -SO₂-. Examples of the C₁₋₆ alkylene group include a methylene group, an ethylene group, a trimethylene group, a tetramethylene group, a hexamethylene group, and the like. Moreover, examples of the C₁₋₄ alkyl group as a substituent include a methyl group, an ethyl group, an n-propyl group, an isopropyl group, an n-butyl group, an isobutyl group, and the like. Preferable examples of the C₁₋₆ alkylene group substituted with a C₁₋₄ alkyl group include -CH(CH₃)-, -C(CH₃)₂-, - CH₂CH(CH₃)CH₂-, -CH₂C(CH₃)₂CH₂-, and the like. Y is preferably a bond, an oxygen atom, a methylene group, a dimethylmethylene group, -S-, or -SO₂-; and more preferably a bond, a dimethylmethylene group, an oxygen atom, or -SO₂-.

The rings represented by the formula (2) are substituted with R^{Xa}, R^{Xb}, R^{Xc}, and R^{Xc}. When the X ring of the formula (1) is rings represented by the formula (2), when three of R^{Xa} to R^{Xd} are hydrogen atoms, halogen atoms, or lower carbon substituents, and when the other one is a group of the formula (3), one of the X¹ ring and X² ring may be substituted with a group of the formula (3). In this case, the rings represented by the formula (2) are substituted with 0, 1, 2, or 3 halogen atoms or lower carbon substituents, and (number of halogen atoms or lower carbon substituents substituted in X¹ ring : number of halogen atoms or lower carbon substituents substituted in X² ring) can be (1:0), (0:1), (2:0), (1:1), (0:2), (3:0), (2:1), (1:2), or (0:3). When two of R^{Xa} to R^{Xd} are hydrogen atoms, halogen atoms, or lower carbon substituents, and when the other two are groups of the formula (3), one of the X¹ ring and X² ring may be substituted with 2 groups of the formula (3), or the X¹ ring and the X² ring each may be substituted with a group of the formula (3). It is preferable that the X¹ ring and the X² ring each be substituted with a group of the formula (3). In this case, the rings represented by the formula (2) are substituted with 0, 1, or 2 halogen atoms or lower carbon substituents, and (number of halogen atoms or lower carbon substituents substituted in X¹ ring : number of halogen atoms or lower carbon substituents substituted in X² ring) can be (1:0), (0:1), (2:0), (1:1), or (0:2) . When one of R^{Xa} to R^{Xd} is a hydrogen atom, a halogen atom, or a lower carbon substituent, and when the other three are groups of the formula (3), one of the X¹ ring and X² ring may be substituted with 3 groups of the formula (3); the X¹ ring may be substituted with 2 groups of the formula (3), and the X² ring may be substituted with 1 group of the formula (3); or the X¹ ring may be substituted with 1 group of the formula (3), and the X² ring may be substituted with 2 groups of the formula (3). It is preferable that the X¹ ring be substituted with 2 groups of the formula (3), and the X² ring be substituted with 1 group of the formula (3) ; or that the X¹ ring be substituted with 1 group of the formula (3), and the X² ring be substituted with 2 groups of the formula (3). In this case, the rings represented by the formula (2) are substituted with 0 or 1 halogen atom or lower carbon substituent, and (number of halogen atoms or lower carbon substituents substituted in X¹ ring : number of halogen atoms or lower carbon substituents substituted in X² ring) may be (1:0) or (0:1) . When all of R^{Xa} to R^{Xd} are groups of the formula (3), one of the X¹ ring and the X² ring may be substituted with 4 groups of the formula (3) ; the X¹ ring may be substituted with 3 groups of the formula (3), and the X² ring may be substituted with 1 group of the formula (3) ; the X¹ ring may be substituted with 1 group of the formula (3), and the X² ring may be substituted with 3 groups of the formula (3) ; or the X¹ ring may be substituted with 2 groups of the formula (3), and the X² ring may be substituted with 2 groups of the formula (3). It is preferable that the X¹ ring be substituted with 2 groups of the formula (3), and the X² ring be substituted with 2 groups of the formula (3).

As a group of the formula (1), a tetravalent group represented by the formula (1'): 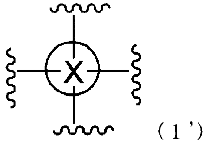
wherein in the formula (1'), X ring is as defined above;
is particularly preferably a group represented by the following formula. Specifically, the group is represented by the following formula:

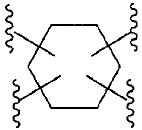

or

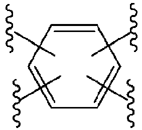

or 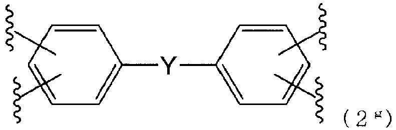 wherein in the formula (2^{g}), Y is as defined above.

In the formula (3), R¹ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom (preferably an oxygen atom). The one or more carbon atoms are preferably carbon atoms that are not directly bonded to the silicon atom. The one or more carbon atoms that may be replaced are one or plural (e.g., 2, 3, 4, 5, or 6) carbon atoms, and preferably one carbon atom. In terms of ease of synthesis etc., it is preferable that R¹ bonded to the same silicon atom be the same. It is more preferable that all R¹ present in the formula (1) be the same.

The C₁₋₁₈ alkyl group represented by R¹ is, for example, a linear or branched alkyl group. Examples include a methyl group, an ethyl group, an n-propyl group, an isopropyl group, an n-butyl group, an isobutyl group, a tert-butyl group, an n-pentyl group, a neopentyl group, a tert-pentyl group, an n-hexyl group, an n-heptyl group, a 2,2,4-trimethylpentyl group, an n-octyl group, an isooctyl group, an n-nonyl group, an n-decyl group, an n-dodecyl group, and the like. Preferable is a C₁₋₁₀ alkyl group, more preferable is a C₁₋₆ alkyl group, even more preferable is a C₁₋₃ alkyl group, and particularly preferable is a methyl group.

The C₂₋₉ alkenyl group represented by R¹ is, for example, a linear or branched alkenyl group. Examples include a vinyl group, an allyl group, a 2-propenyl group, a butenyl group, a pentenyl group, a hexenyl group, a heptenyl group, an octenyl group, a nonenyl group, and the like. Preferable is a C₂₋₄ alkenyl group.

The cycloalkyl group represented by R¹ is, for example, a 3- to 8-membered ring cycloalkyl group. Examples include a cyclopentyl group, a cyclohexyl group, a cycloheptyl group, a methylcyclohexyl group, and the like.

The aryl group represented by R¹ is, for example, a monocyclic or bicyclic aryl group. Examples include a phenyl group, a tolyl group, a xylyl group, an ethyl phenyl group, a naphthyl group, and the like. Of these, a phenyl group is preferable.

The aralkyl group represented by R¹ is, for example, a C₁₋₄ alkyl group substituted with an aryl group (particularly a phenyl group). Examples include a benzyl group, an α-phenethyl group, a β-phenethyl group, a β-methylphenethyl group, and the like.

R¹ is preferably a C₁₋₃ alkyl group, and more preferably a methyl group.

In the formula (3), R² is a C₁₋₁₈ alkylene group. The alkylene group is a linear or branched alkylene group, and preferably a linear alkylene group. Examples include a methylene group, a methylmethylene group, an ethylmethylene group, a dimethylmethylene group, a diethylmethylene group, a dimethylene group (-CH₂CH₂-), a trimethylene group (-CH₂CH₂CH₂-) , a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, and the like. Specific examples include a C₂₋₁₈ alkylene group, preferably a C₂₋₁₀ alkylene group, more preferably a C₂₋₈ alkylene group, even more preferably a C₂₋₆ alkylene group, and particularly preferably a C₂₋₅ alkylene group.

One or more carbon atoms of the C₁₋₁₈ alkylene group may be replaced by at least one atom selected from the group consisting of an oxygen atom and a nitrogen atom (preferably an oxygen atom). The one or more carbon atoms are preferably carbon atoms that are not directly bonded to the silicon atom, and the 3- to 8-membered ring or epoxy ring. Moreover, the one or more carbon atoms that may be replaced are one or plural (e.g., 2, 3, 4, 5, or 6) carbon atoms, and preferably one carbon atom.

When the side of R² binding to the silicon atom is expressed as (*), examples of this group include (*)-C₂₋₉ alkylene-O-C₁₋₈ alkylene-, preferably (*)-C₂₋₄ alkylene-O-C₁₋₃ alkylene-, more preferably (*)-C₂₋₄ alkylene-O-C₁₋₂ alkylene-, and particularly preferably (*)-C₃ alkylene-O-methylene-.

Specific examples include (*)-(CH₂)₂-O-CH₂-, (*)-(CH₂)₃-O-CH₂-, (*)-(CH₂)₃-O-(CH₂)₂-, (*)-(CH₂)₅-O-(CH₂)₄-, and the like; of these, (*)-(CH₂)₃-O-CH₂ is preferable.

In the formula (3), m is an integer of 0 to 6 (i.e., 0, 1, 2, 3, 4, 5, or 6). Moreover, n is an integer of 0 to 3 (i.e., 0, 1, 2, or 3). The group bonded to R² of the formula (3) (on the side not binding to the silicon atom) is represented by the formula (4) (hereafter also referred to as "the group of the formula (4)"), as shown below.

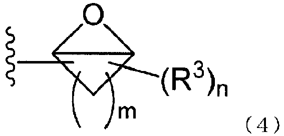

The group of the formula (4) wherein m is an integer of 1 to 6 is specifically described by the following structural formulas.

When m = 1,

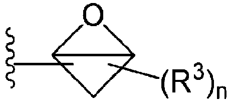

When m = 2,

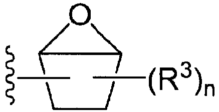

When m = 3,

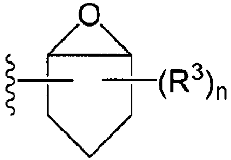

When m = 4,

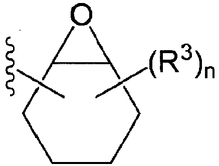

When m = 5,

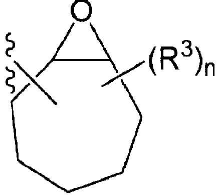

When m = 6,

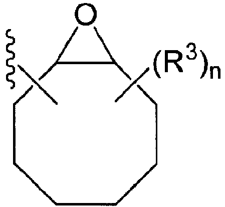

When m is 0, only an epoxy ring remains, and n is an integer of 0 to 3; thus, the group of the formula (4) is a group represented by any of the following formulas:

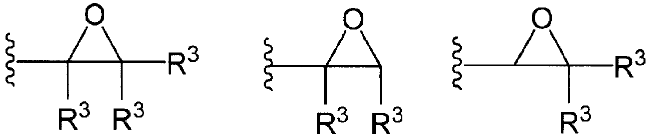

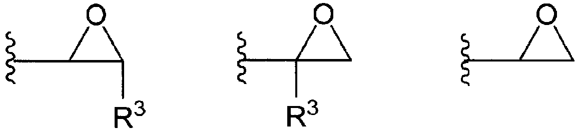

In the formula (3), R² and R³ bind to a 3- to 8-membered ring or an epoxy ring. n represents the number of R³ binding to the 3- to 8-membered ring or the epoxy ring.

In the formula (3), R³ is the same or different, and is a C₁₋₁₈ alkyl group, a C₂₋₉ alkenyl group, a cycloalkyl group, an aryl group, or an aralkyl group. One or more carbon atoms of these groups may be replaced by at least one atom selected from the group consisting of an oxygen atom and a nitrogen atom. The one or more carbon atoms are preferably carbon atoms that are not directly bonded to the 3- to 8-membered ring or epoxy ring. Moreover, the one or more carbon atoms that may be replaced are one or plural (e.g., 2, 3, 4, 5, or 6) carbon atoms, and preferably one carbon atom.

Examples of the C₁₋₁₈ alkyl group, C₂₋₉ alkenyl group, cycloalkyl group, aryl group, and aralkyl group represented by R³ include the same corresponding substituents represented by R¹ described above.

R³ is preferably a C₁₋₃ alkyl group, and more preferably a methyl group or an ethyl group.

Preferable examples of the group of the formula (3) include groups wherein R¹, R², R³, m, and n are as defined above; all R¹ are the same; and all R³ are the same (when there are plural R³). The number of this group present in the epoxy resin represented by the formula (1) is 1, 2, 3, or 4; and they may be the same or different, and are preferably the same.

Particularly preferable specific examples of the group of the formula (4) include groups wherein R³ is as defined above; m is 0, 1, 2, 3, or 4; and n is 0, 1, or 2. More preferable among these are, for example, the following groups (all R³ are as defined above):

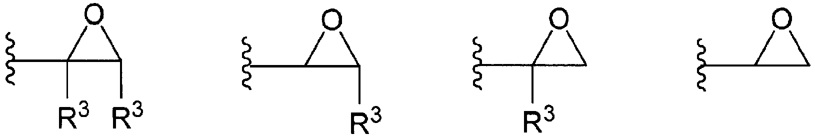

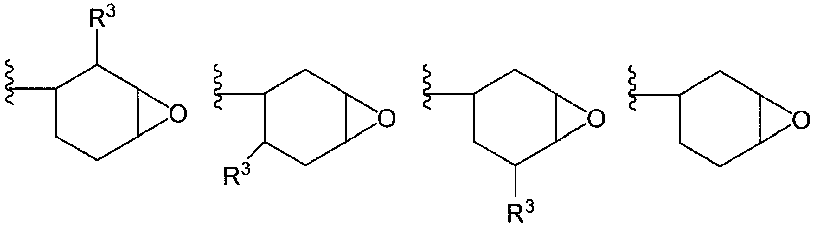

The number of groups of the formula (4) present in the epoxy resin represented by the formula (1) is 1, 2, 3, or 4; and they may be the same or different, and are preferably the same.

Moreover, one or more hydrogen atoms bonded to one or more carbon atoms that constitute the hydrocarbon ring constituting the X ring, and that are not bonded to R^{Xa}, R^{Xb}, R^{Xc}, or R^{Xd}, may be replaced by a lower carbon substituent or a halogen atom (preferably a lower carbon substituent). That is, when the X ring is a saturated hydrocarbon ring or an unsaturated hydrocarbon ring, or rings having a structure in which 2 to 6 saturated hydrocarbon rings and/or unsaturated hydrocarbon rings are condensed, one or more hydrogen atoms bonded to one or more carbon atoms that constitute these rings, and that are not bonded to R^{Xa}, R^{Xb}, R^{Xc}, or R^{Xd}, may be replaced by a lower carbon substituent or a halogen atom (preferably a lower carbon substituent). When the X ring is rings having a structure in which 2 saturated hydrocarbon rings and/or unsaturated hydrocarbon rings are connected, one or more hydrogen atoms bonded to one or more carbon atoms that constitute theses connected saturated hydrocarbon rings and/or unsaturated hydrocarbon rings, and that are not bonded to R^{Xa}, R^{Xb}, R^{Xc}, or R^{Xd}, may be replaced by a lower carbon substituent or a halogen atom (preferably a lower carbon substituent). When the case in which the X ring is rings represented by the formula (2) is explained in detail, one or more hydrogen atoms bonded to one or more carbon atoms that constitute the X¹ ring and X² ring, and that are not bonded to R^{Xa}, R^{Xb}, R^{Xc}, or R^{Xd}, may be replaced by a lower carbon substituent or a halogen atom (preferably a lower carbon substituent).

In the present specification, carbon atoms that constitute the hydrocarbon ring constituting the X ring, and that are not bonded to R^{Xa}, R^{Xb}, R^{Xc}, and R^{Xd}, are also referred to as "R^{Xa-d} non-binding carbon atoms."

The lower carbon substituent or halogen atom that may replace one or more hydrogen atoms bonded to one or more R^{Xa-d} non-binding carbon atoms is preferably singly bonded to one R^{Xa-d} non-binding carbon atom. That is, when hydrogen atoms bonded to R^{Xa-d} non-binding carbon atoms are replaced, only one of the hydrogen atoms bonded to the R^{Xa-d} non-binding carbon atoms is preferably replaced by a lower carbon substituent or halogen atom. Moreover, the number of substituents (i.e., the total number of lower carbon substituents and halogen atoms) is more preferably less than the number of R^{Xa-d} non-binding carbon atoms. More specifically, the number of substituents is preferably 1 to 6 (1, 2, 3, 4, 5, or 6), more preferably 1 to 4, and even more preferably 1 or 2. Particularly when the X ring is rings represented by the formula (2), one or more hydrogen atoms to be replaced are preferably hydrogen atoms bonded to carbon atoms that are not bonded to Y.

When at least one of R^{Xa}, R^{Xb}, R^{Xc}, and R^{Xd} is a lower carbon substituent, and when at least one lower carbon substituent is bonded to an R^{Xa-d} non-binding carbon atom, all of the lower carbon substituents are preferably the same. That is, when there are lower carbon substituents among R^{Xa}, R^{Xb}, R^{Xc}, and R^{Xd}, and when there are lower carbon substituents bonded to R^{Xa-d} non-binding carbon atoms, all of the lower carbon substituents are preferably the same. Moreover, when at least one of R^{Xa}, R^{Xb}, R^{Xc}, and R^{Xd} is a halogen atom, and when at least one halogen atom is bonded to an R^{Xa-d} non-binding carbon atom, all of the halogen atoms are preferably the same. That is, when there are halogen atoms among R^{Xa}, R^{Xb}, R^{Xc}, and R^{Xd}, and when there are halogen atoms bonded to R^{Xa-d} non-binding carbon atoms, all of the halogen atoms are preferably the same.

More specifically, for example, when the tetravalent group represented by the above formula (1') is the following: 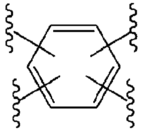 preferable examples of the epoxy resin represented by the formula (1) include an epoxy resin represented by the formula (1-X1): 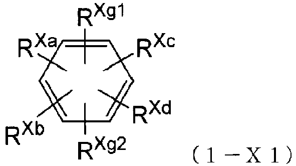 wherein in the formula (1-X1), R^{Xa}, R^{Xb}, R^{Xc}, and R^{Xd} are as defined above; and R^{Xg1} and R^{Xg2} are the same or different, and each is a hydrogen atom, a lower alkyl group, a lower alkoxy group, or a lower alkenyl group.

In the formula (1-X1), R^{Xa}, R^{Xb}, R^{Xc}, R^{Xd}, R^{Xg1}, and R^{Xg2} are more preferably each bonded to a different carbon atom on the benzene ring. Among the epoxy resins represented by the formula (1-X1), one wherein R^{Xg1} and R^{Xg2} are hydrogen atoms is preferable.

More preferable examples of the epoxy resin represented by the formula (1-X1) include:
an epoxy resin represented by the formula (1-X1a): 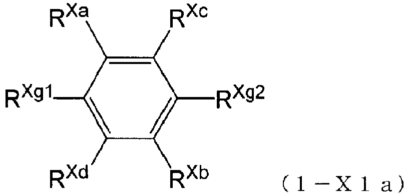
wherein in the formula (1-X1a), R^{Xa}, R^{Xb}, R^{Xc}, and R^{Xd} are as defined above; and R^{Xg1} and R^{Xg2} are as defined above; and
an epoxy resin represented by the formula (1-X1b) : 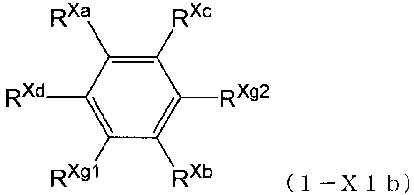
wherein in the formula (1-X1b), R^{Xa}, R^{Xb}, R^{Xc}, and R^{Xd} are as defined above; and R^{Xg1} and R^{Xg2} are as defined above.

More preferable among the epoxy resins represented by the formula (1-X1a) are, for example, those wherein R^{Xa} and R^{Xb} are hydrogen atoms, R^{Xc} and R^{Xd} are groups of the formula (3), and R^{Xg1} and R^{Xg2} are hydrogen atoms; and those wherein R^{Xa} and R^{Xc} are hydrogen atoms, R^{Xb} and R^{Xd} are groups of the formula (3), and R^{Xg1} and R^{Xg2} are hydrogen atoms.

More preferable among the epoxy resins represented by the formula (1-X1b) are, for example, those wherein R^{Xa} is a hydrogen atom, R^{Xb}, R^{Xc}, and R^{Xd} are groups of the formula (3), and R^{Xg1} and R^{Xg2} are hydrogen atoms.

Moreover, when the tetravalent group represented by the above formula (1') is a group represented by the following formula:

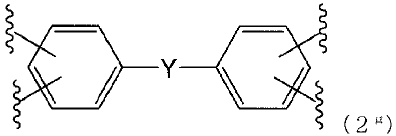

wherein in the formula (2^{g}), Y is as defined above;
preferable examples of the epoxy resin represented by the formula (1) also include an epoxy resin represented by the formula (1-X2) : 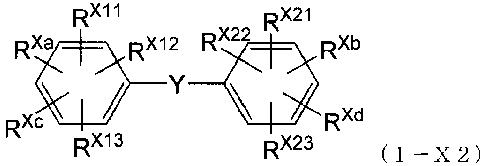
wherein in the formula (1-X2), Y is as defined above; R^{Xa}, R^{Xb}, R^{Xc}, and R^{Xd} are as defined above; and R^{X11}, R^{X12}, and R^{X13}, as well as R^{X21}, R^{X22}, and R^{X23} are the same or different, and each is a hydrogen atom, a lower alkyl group, a lower alkoxy group, or a lower alkenyl group.

In the formula (1-X2), R^{Xa}, R^{Xc}, R^{X11}, R^{X12}, and R^{X13} preferably each bind to a different carbon atom; and R^{Xb}, R^{Xd}, R^{X21}, R^{X22}, and R^{X23} more preferably each bind to a different carbon atom. None of R^{Xa}, R^{Xb}, R^{Xc}, R^{Xd}, R^{X11}, R^{X12}, R^{X13}, R^{X21}, R^{X22}, and R^{X23} binds to a carbon atom bonded to Y.

More preferable among the epoxy resins represented by the formula (1-X2) are:
an epoxy resin represented by the formula (1-X2a): 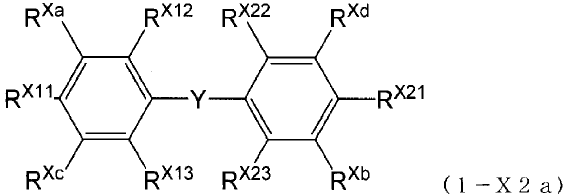
wherein in the formula (1-X2a), Y is as defined above; R^{Xa}, R^{Xb}, R^{Xc}, and R^{Xd} are as defined above; and R^{X11}, R^{X12}, and R^{X13}, as well as R^{X21}, R^{X22}, and R^{X23} are the same or different, and each is a hydrogen atom, a lower alkyl group, a lower alkoxy group, or a lower alkenyl group;
an epoxy resin represented by the formula (1-X2b):

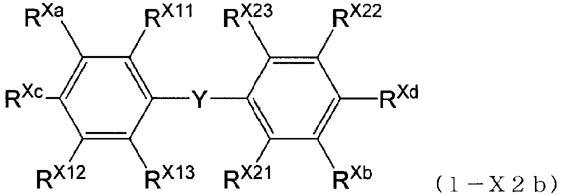

wherein in the formula (1-X2b), Y is as defined above; R^{Xa}, R^{Xb}, R^{Xc}, and R^{Xd} are as defined above; and R^{X11}, R^{X12}, and R^{X13}, as well as R^{X21}, R^{X22}, and R^{X23} are the same or different, and each is a hydrogen atom, a lower alkyl group, a lower alkoxy group, or a lower alkenyl group; and
an epoxy resin represented by the formula (1-X2c): 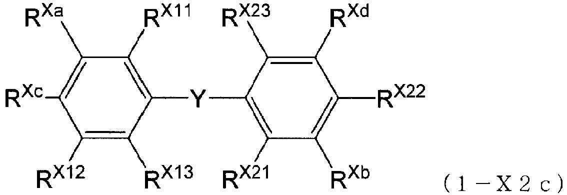
wherein in the formula (1-X2c), Y is as defined above; R^{Xa}, R^{Xb}, R^{Xc}, and R^{Xd} are as defined above; and R^{X11}, R^{X12}, and R^{X13}, as well as R^{X21}, R^{X22}, and R^{X23} are the same or different, and each is a hydrogen atom, a lower alkyl group, a lower alkoxy group, or a lower alkenyl group.

More preferable among the epoxy resins represented by the formula (1-X2a) are, for example, those wherein R^{Xa}, R^{Xb}, R^{Xc}, and R^{Xd} are groups of the formula (3) ; R^{X11} and R^{X21} are lower carbon substituents; and R^{X12}, R^{X13}, R^{X22}, and R^{X23} are hydrogen atoms. Particularly preferable are those wherein Y is a C₁₋₆ alkylene group that may be substituted with a C₁₋₄ alkyl group (particularly -C(CH₃)₂-); R^{Xa}, R^{Xb}, R^{Xc}, and R^{Xd} are groups of the formula (3) ; R^{X11} and R^{X21} are lower alkoxy groups; and R^{X12}, R^{X13}, R^{X22}, and R^{X23} are hydrogen atoms. In these cases, it is more preferable that all of the groups of the formula (3) as R^{Xa}, R^{Xb}, R^{Xc}, and R^{Xd} be the same, and that the lower carbon substituents as R^{X11} and R^{X21} be the same.

Preferable among the epoxy resins represented by the formula (1-X2b) are, for example, those wherein R^{Xa} and R^{Xb} are hydrogen atoms; R^{Xc} and R^{Xd} are groups of the formula (3) ; and R^{X11}, R^{X12}, R^{X13}, R^{X21} R^{X22}, and R^{X23} are hydrogen atoms. In this case, it is more preferable that the groups of the formula (3) as R^{Xc} and R^{Xd} be the same.

Preferable among the epoxy resins represented by the formula (1-X2c) are, for example, those wherein R^{Xa} is a hydrogen atom; R^{Xb}, R^{Xc}, and R^{Xd} are groups of the formula (3) ; and R^{X11}, R^{X12}, R^{X13}, R^{X21}, R^{X22}, and R^{X23} are hydrogen atoms. In this case, it is more preferable that the groups of the formula (3) as R^{Xb}, R^{Xc}, and R^{Xd} be the same.

In the present specification, the explanations relating to the X ring, R^{Xa}, R^{Xb}, R^{Xc}, and R^{Xd} in the formula (1), and R¹, R², R³, m, and n in the group of the formula (3), including the explanation about the group of the formula (4), can be combined in any way. Any epoxy resins represented by combinations thereof can be also used in the present invention.

The formula (1) can satisfy any of the following:
(iia) one or more hydrogen atoms bonded to one or more R^{Xa-d} non-binding carbon atoms are not replaced; R^{Xa} and R^{Xb} of R^{Xa}, R^{Xb}, R^{Xc}, and R^{Xd} are hydrogen atoms; and R^{Xc} and R^{Xd} are groups of the formula (3);
(iiia) one or more hydrogen atoms bonded to one or more R^{Xa-d} non-binding carbon atoms are not replaced; R^{Xa} of R^{Xa}, R^{Xb}, R^{Xc}, and R^{Xd} is a hydrogen atom; and R^{Xb}, R^{Xc}, and R^{Xd} are groups of the formula (3) ; or
(iva) one or more hydrogen atoms bonded to one or more R^{Xa-d} non-binding carbon atoms are not replaced; and all of R^{Xa}, R^{Xb}, R^{Xc}, and R^{Xd} are groups of the formula (3) .

In the case of (iia), preferable examples of the epoxy resin represented by the formula (1) include an epoxy resin represented by the following formula (1-iia): 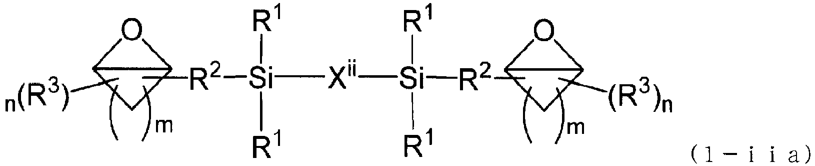 wherein Xⁱⁱ is a divalent group obtained by removing two hydrogen atoms from a hydrocarbon ring, or a divalent group represented by the formula (2^{g}-iia) : 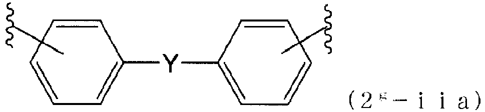
wherein Y is as defined above; and
R¹, R², R³, m, and n are as defined above.
R¹, R², R³, m, and n each may be the same or different, and are preferably the same.

The divalent group represented by Xⁱⁱ is preferably a cyclohexane-1,4-diyl group or a 1,4-phenylene group; and more preferably a 1,4-phenylene group.

Preferable among the divalent groups represented by the formula (2^{g}-iia) is a group represented by the formula (2^{g}-iia') : 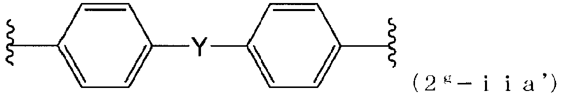 wherein Y is as defined above.

In the formula (2^{g}-iia'), Y is preferably a bond, a dimethylmethylene group, an oxygen atom, or -SO₂-.

Xⁱⁱ is preferably a cyclohexane-1,4-diyl group, a 1,4-phenylene group, or a group of the formula (2^{g}-iia'); and more preferably a 1,4-phenylene group.

The present invention can more preferably use, for example, an epoxy resin represented by the formula (1-iia), wherein m is the same and is 0, 1, 2, 3, or 4 (particularly preferably m is the same and is 0 or 4); n is the same and is 0 (that is, the ring is not substituted with R³); Xⁱⁱ is a divalent group obtained by removing two hydrogen atoms from a hydrocarbon ring (particularly preferably a benzene ring); R¹ is the same and is a C₁₋₃ alkyl group; and R² is the same and is a C₂₋₆ alkylene group, wherein one carbon atom that is not directly bonded to the silicon atom, and the 3- to 6-membered ring or epoxy ring may be replaced by an oxygen atom.

In the case of (iiia), the epoxy resins represented by the formula (1) preferably include an epoxy resin represented by the following formula (1-iiia): 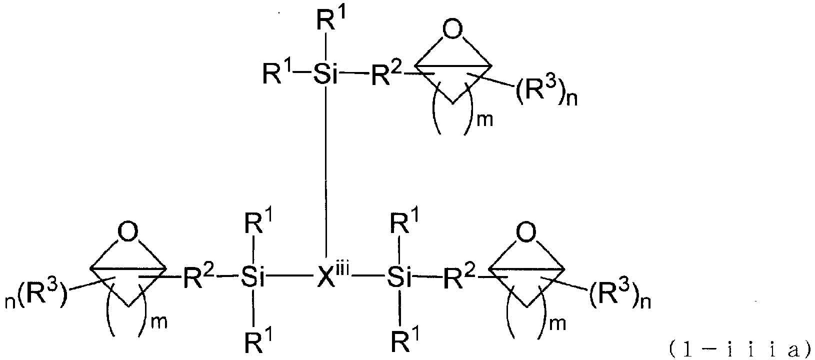 wherein Xⁱⁱⁱ is a trivalent group obtained by removing three hydrogen atoms from a hydrocarbon ring, or a trivalent group represented by the formula (2^{g}-iiia) : 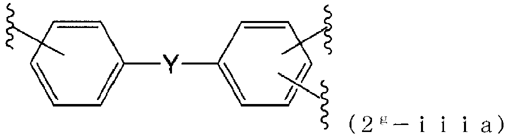
wherein Y is as defined above; and
R¹, R², R³, m, and n are as defined above.
R¹, R², R³, m, and n each may be the same or different, and are preferably the same.

Preferable examples of the trivalent group represented by Xⁱⁱⁱ include the following groups:

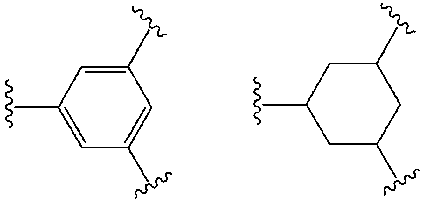

Preferable among the trivalent groups represented by the formula (2^{g}-iiia) include a group represented by the formula (2^{g}-iiia') : 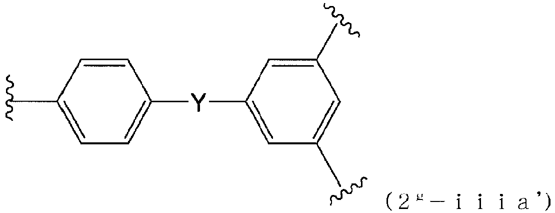 wherein Y is as defined above.

In the formula (2^{g}-iiia'), Y is particularly preferably a bond, a dimethylmethylene group, an oxygen atom, or -SO₂-.

The present invention can more preferably use, for example, an epoxy resin represented by the formula (1-iiia), wherein m is the same and is 0, 1, 2, 3, or 4 (particularly preferably m is the same and is 0 or 4); n is the same and is 0 (that is, the ring is not substituted with R³); Xⁱⁱⁱ is a trivalent group obtained by removing three hydrogen atoms from a hydrocarbon ring (particularly preferably a benzene ring); R¹ is the same and is a C₁₋₃ alkyl group; and R² is the same and is a C₂₋₆ alkylene group, wherein one carbon atom that is not directly bonded to the silicon atom and the 3- to 6-membered ring or epoxy ring may be replaced by an oxygen atom.

In the case of (iva), the epoxy resins represented by the formula (1) include an epoxy resin represented by the following formula (1-iva): 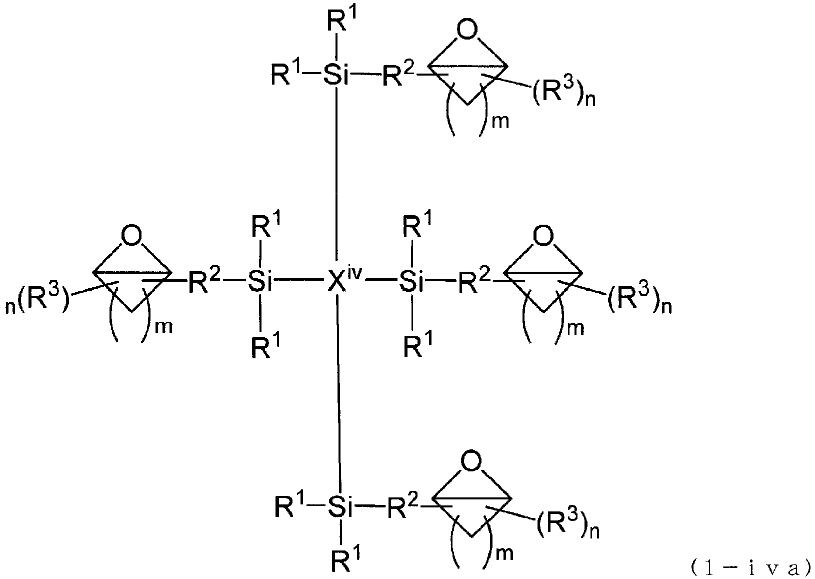
wherein X^{iv} is a tetravalent group represented by the above formula (1'), wherein one or more hydrogen atoms bonded to one or more R^{Xa-d} non-binding carbon atoms in the X ring are not replaced; and R¹, R², R³, m, and n are as defined above.
R¹, R², R³, m, and n each may be the same or different, and are preferably the same.

Preferable examples of the tetravalent group represented by X^{iv} include the following groups:

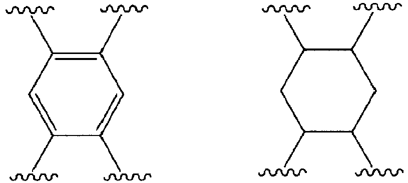

As the tetravalent group represented by X^{iv}, among tetravalent groups represented by the formula (2^{g}), wherein one or more hydrogen atoms bonded to one or more R^{Xa-d} non-binding carbon atoms are not replaced, preferable is a group represented by the formula (2^{g}-iva') : 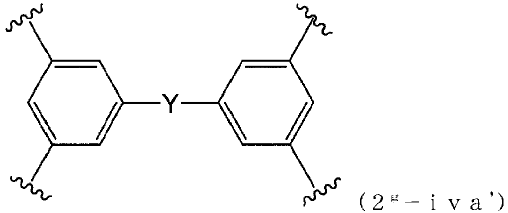 wherein Y is as defined above.

In the formula (2^{g}-iva'), Y is particularly preferably a bond, a dimethylmethylene group, an oxygen atom, or -SO₂-.

The present invention can more preferably use, for example, an epoxy resin represented by the formula (1-iva), wherein m is the same and is 0, 1, 2, 3, or 4 (particularly preferably m is the same and is 0 or 4); n is the same and is 0 (that is, the ring is not substituted with R³); X^{iv} is a tetravalent group obtained by removing four hydrogen atoms from a hydrocarbon ring (particularly preferably a benzene ring); R¹ is the same and is a C₁₋₃ alkyl group; and R² is the same and is a C₂₋₆ alkylene group, wherein one carbon atom that is not directly bonded to the silicon atom and the 3- to 6-membered ring or epoxy ring may be replaced by an oxygen atom.

More preferable among the epoxy resins represented by the formula (1) are specifically, for example, compounds represented by the formula (1-IIa): 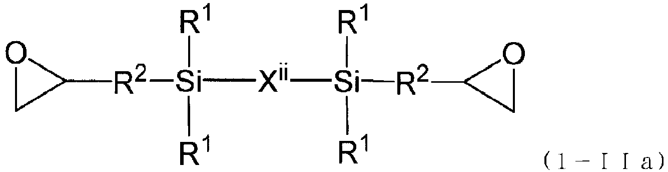 wherein R¹, R², and Xⁱⁱ are as defined above.

Preferable among the compounds represented by the formula (1-IIa) are compounds wherein Xⁱⁱ is a 1,4-phenylene group or a group represented by the formula (2^{g}-iia') (preferably a 1,4-phenylene group); R¹ is the same or different (preferably the same), and is a C₁₋₃ alkyl group (particularly a methyl group); and R² is the same or different (preferably the same), and is a C₂₋₆ alkylene group, (*)-(CH₂)₂-O-CH₂-, (*)-(CH₂)₃-O-CH₂-, (*)-(CH₂)₃-O-(CH₂)₂-, or (*)-(CH₂)₅-O-(CH₂)₄-. (*) represents the side of R² binding to the silicon atom, as described above. More preferable among the epoxy resins represented by the above formula (1-IIa) is:
an epoxy resin represented by the formula (1-IIa1) : 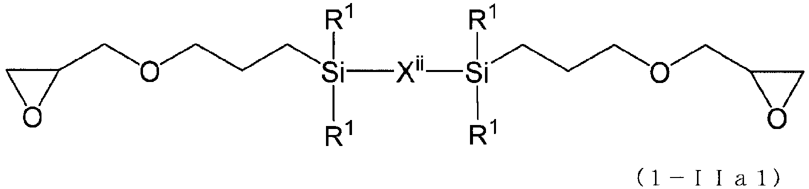
wherein R¹ and Xⁱⁱ are as defined above; or
an epoxy resin represented by the formula (1-IIa2) :

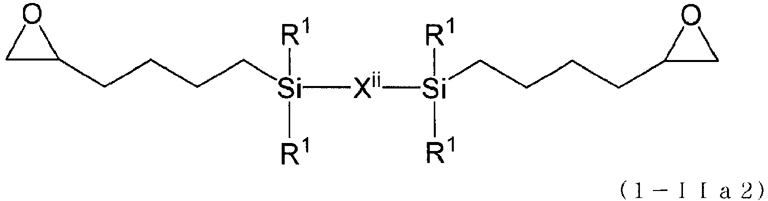

wherein R¹ and Xⁱⁱ are as defined above.
R¹ may be the same or different, and is preferably the same.

More preferably, in the formula (1-IIa1) or (1-IIa2), R¹ is the same or different (preferably the same), and is a C₁₋₃ alkyl group (particularly a methyl group); and Xⁱⁱ is a 1,4-phenylene group or a group represented by the formula (2^{g}-iia').

More preferable among the epoxy resins represented by the formula (1) include an epoxy resin represented by the formula (1-IIb) : 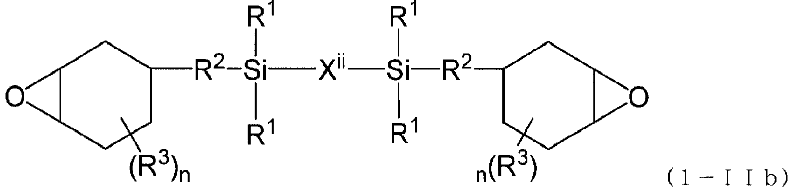
wherein R¹, R², R³, Xⁱⁱ, and n are as defined above.
R¹, R², R³, and n each may be the same or different, and are preferably the same.

More preferably, in the formula (1-IIb), Xⁱⁱ is a 1,4-phenylene group or a group represented by the formula (2^{g}-iia') (preferably a 1,4-phenylene group); R¹ is the same or different (preferably the same), and is a C₁₋₃ alkyl group (particularly a methyl group); both n is 0 (that is, the ring is not substituted with R³) ; and R² is the same or different (preferably the same), and is a C₂₋₆ alkylene group (preferably a dimethylene group: - (CH₂)₂-).

More preferable among the epoxy resins represented by the formula (1) is an epoxy resin represented by the formula (1-IIIa) : 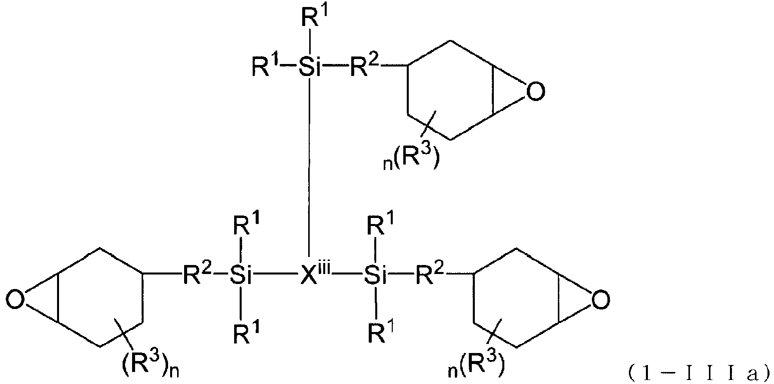
wherein R¹, R², R³, Xⁱⁱⁱ, and n are as defined above.
R¹, R², R³, and n each may be the same or different, and are preferably the same.

More preferably, in the formula (1-IIIa), Xⁱⁱⁱ is

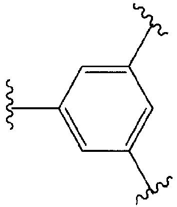

or 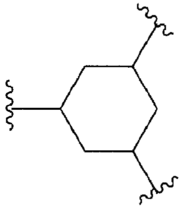 or a group represented by the formula (2^{g}-iiia') ; R¹ is the same or different (preferably the same), and is a C₁₋₃ alkyl group (particularly a methyl group); both n is 0 (that is, the ring is not substituted with R³) ; and R² is the same or different (preferably the same), and is a C₂₋₆ alkylene group (preferably a dimethylene group: -(CH₂)₂-).

In the epoxy resin composition of the present invention, the epoxy resins represented by the formula (1) can be used singly or in combination of two or more.

The epoxy resin represented by the formula (1) can be produced by or according to a known method, for example, based on or according to the disclosure of PTL 2 (GB1123960B). Moreover, the epoxy resin represented by the formula (1-iia) can be produced by, for example, a reaction represented by the following reaction formula: 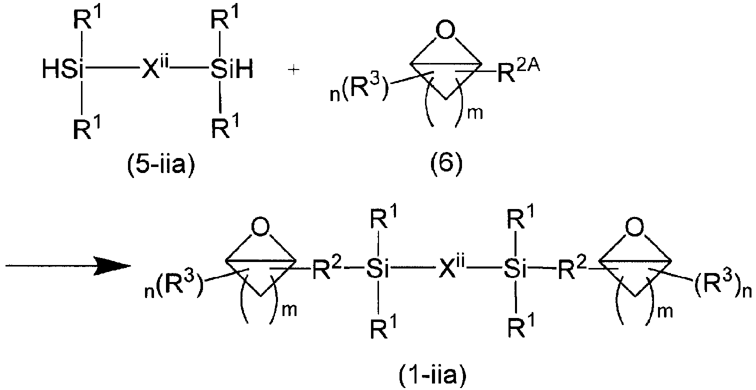 wherein R^{2A} is a C₂₋₁₈ alkenyl group, wherein one or more carbon atoms of this group may be replaced by at least one atom selected from the group consisting of an oxygen atom and a nitrogen atom; and R¹, R², R³, and Xⁱⁱ are as defined above.

The C₂₋₁₈ alkenyl group represented by R^{2A} is a linear or branched alkenyl group, and preferably a linear alkenyl group. Specific examples include a vinyl group, an allyl group, a propenyl group, a butenyl group, a pentenyl group, a hexenyl group, a heptenyl group, an octenyl group, a norbornenyl group, a cyclohexenyl group, and the like. A C₂₋₁₀ alkenyl group is preferable; a C₂₋₈ alkenyl group is more preferable; a C₂₋₆ alkenyl group is even more preferable; and a vinyl group, an allyl group, or a butenyl group is particularly preferable. The alkenyl group is preferably an α-alkenyl group.

One or more carbon atoms of these C₂₋₁₈ alkylene groups may be replaced by at least one atom selected from the group consisting of an oxygen atom and a nitrogen atom (preferably an oxygen atom). The one or more carbon atoms are preferably carbon atoms that are not directly bonded to the epoxy ring. Moreover, the one or more carbon atoms that may be replaced are one or plural (e.g., 2, 3, 4, 5, or 6) carbon atoms, and preferably one carbon atom. Examples of this group include C₂₋₉ alkenyl-O-C₁₋₈ alkylene-, preferably C₂₋₄ alkenyl-O-C₁₋₃ alkylene-, more preferably C₂₋₄ alkenyl-O-C₁₋₂ alkylene-, and particularly preferably C₃ alkenyl-O-CH₂-. Specific examples include CH₂ = CHO-CH₂-, CH₂ = CH-CH₂-O-CH₂-, CH₂ = CH-CH₂-O-(CH₂)₂-, CH₂ = CH-(CH₂)₃-O-(CH₂)₄-, and the like; among these, CH₂ = CH-CH₂-O-CH₂-(allyloxymethyl group) is preferable.

The epoxy resin represented by the formula (1-iia) can be produced by hydrosilylation of the compound represented by the formula (5-iia) and the compound represented by the formula (6). Hydrosilylation can be generally performed in the presence of a catalyst in the presence or absence of a solvent. Moreover, when a compound represented by the formula (5-iiia): 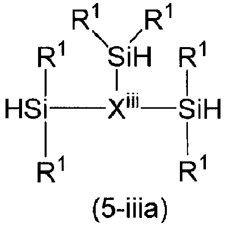 wherein R¹ and Xⁱⁱⁱ are as defined above; or
the formula (5-iva): 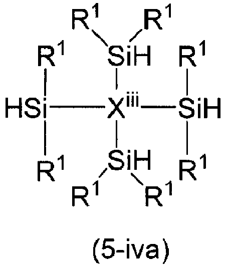 wherein R¹ and Xⁱⁱⁱ are as defined above; or
the formula (5-ia): 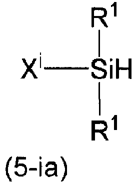
wherein Xⁱ is a monovalent group obtained by removing one hydrogen atom from a hydrocarbon ring, and R¹ is as defined above;
is used in place of the compound represented by the formula (5-iia), an epoxy resin represented by the above formula (1-iiia) or (1-iva), or an epoxy resin having a structure in which one group of the formula (3) is bonded to a hydrocarbon ring can also be produced. Moreover, various compounds represented by the formula (1) can be produced by using compounds having a structure in which Xⁱ to X^{iv} are each replaced by a monovalent group obtained by removing one hydrogen atom from the X ring, a divalent group obtained by removing two hydrogen atoms from the X ring, a trivalent group obtained by removing three hydrogen atoms from the X ring, or a tetravalent group obtained by removing four hydrogen atoms from the X ring.

The catalyst used in hydrosilylation may be a known catalyst. Examples include platinum-based catalysts, such as platinum carbon, chloroplatinic acid, olefin complexes of platinum, alkenylsiloxane complexes of platinum, and carbonyl complexes of platinum; rhodium-based catalysts, such as tris(triphenylphosphine)rhodium; and iridium-based catalysts, such as bis(cyclooctadienyl)dichloroiridium. These catalysts may be in the form of solvates (e.g., hydrates, alcoholates, etc.). Further, the catalyst may be used in the form of a solution obtained by dissolving the catalyst in an alcohol (e.g., ethanol) when used. These catalysts can be used singly or in combination of two or more.

The amount of the catalyst used may be an effective amount as the catalyst. For example, the amount of the catalyst used is generally 0.00001 to 20 parts by mass, and preferably 0.0005 to 5 parts by mass, based on the total amount of 100 parts by mass of the compound represented the formula (5-ia), (5-iia), (5-iiia), or (5-iva), and the compound represented by the formula (6).

Although hydrosilylation proceeds without use of a solvent, the reaction can be carried out under milder conditions by using a solvent. Examples of solvents include aromatic hydrocarbon solvents, such as toluene and xylene; aliphatic hydrocarbon solvents, such as hexane and octane; ether solvents, such as tetrahydrofuran and dioxane; alcohol solvents, such as ethanol and isopropanol; and the like. These may be used singly or in combination of two or more.

The amount of the compound represented by the formula (6) is, for example, generally 0.5 to 2 mol, preferably 0.6 to 1.5 mol, and more preferably 0.8 to 1.2 mol, per mol of the Si-H group in the compound represented by the formula (5-ia), (5-iia), (5-iiia), or (5-iva).

The reaction temperature is generally 0°C to 150°C, and preferably 10°C to 120°C. The reaction time is generally about 1 hour to 24 hours.

After completion of the reaction, the solvent is distilled off from the reaction mixture, or a known isolation method is used, thereby obtaining an epoxy resin represented by the formula (1) .

The active ester compound used in the present invention is a compound having ester groups (preferably highly reactive ester groups). Specifically, the active ester compound is preferably a compound having two or more ester groups per molecule. Preferable examples of such compounds include compounds having two or more ester groups per molecule, such as phenol esters, thiophenol esters, N-hydroxyamine esters, and esters of heterocyclic ring hydroxy compounds.

Moreover, the active ester compound is preferably a compound obtained by condensation reaction of a carboxylic acid compound and/or a thiocarboxylic acid compound with a hydroxy compound and/or a thiol compound (i.e., a condensate of at least one member selected from the group consisting of a carboxylic acid compound and a thiocarboxylic acid compound, and at least one member selected from the group consisting of a hydroxy compound and a thiol compound). In particular, in terms of improving heat resistance, a condensate obtained from a carboxylic acid compound and a hydroxy compound is preferable, and a condensate obtained from a carboxylic acid compound, a phenol compound, and/or a naphthol compound is more preferable. Such a condensate (active ester compound) can be preferably used as an epoxy resin curing agent.

Examples of carboxylic acid compounds include benzoic acid, acetic acid, succinic acid, maleic acid, itaconic acid, phthalic acid, isophthalic acid, terephthalic acid, pyromellitic acid, and the like.

Examples of thiocarboxylic acid compounds include thioacetic acid, thiobenzoic acid, and the like.

Examples of hydroxy compounds include phenol compounds and naphthol compounds. Specific examples include hydroquinone, resorcinol, bisphenol A, bisphenol F, bisphenol S, phenol phthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxy benzophenone, trihydroxy benzophenone, tetrahydroxy benzophenone, phloroglucine, benzenetriol, dicyclopentadienyl diphenol, phenol novolac, and the like.

Examples of thiol compounds include benzene dithiol, triazine dithiol, and the like.

As the active ester compound, for example, the active ester compound disclosed in JP2009-235165A, JP2004-277460A, or WO2013/061688 can also be used. It is more preferable to use the active ester compound disclosed in JP2009-235165A. The contents disclosed in the specification and/or drawings of JP2009-235165A, JP2004-277460A, and WO2013/061688 are incorporated into the present specification by reference.

As the active ester compound, an ester compound containing a dicyclopentadienyl diphenol structure is particularly preferable.

The active ester compound is particularly preferably a compound represented by the formula (7): 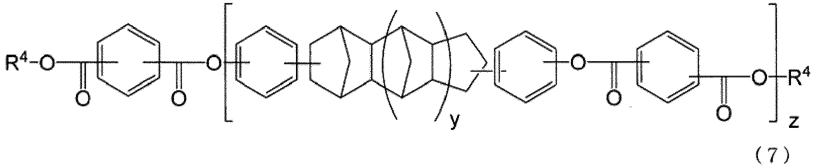
wherein R⁴ is a phenyl group or a naphthyl group, y is an integer of 0 or 1, and z is an average of repeating units and is 0.05 to 2.5.
R⁴ is preferably a naphthyl group. y is preferably 0. z is preferably 0.25 to 1.5. In terms of electric characteristics and heat resistance, it is more preferable that R⁴ is a naphthyl group, y is 0, and z is 0.25 to 1.5.

Moreover, preferable examples of the active ester compound include polyesters having an aryloxycarbonyl group at the molecular chain end, and comprising an aromatic polyvalent carboxylic acid residue and an aromatic polyvalent hydroxy compound residue, wherein the aromatic polyvalent hydroxy compound residue is a group represented the formula (8a): 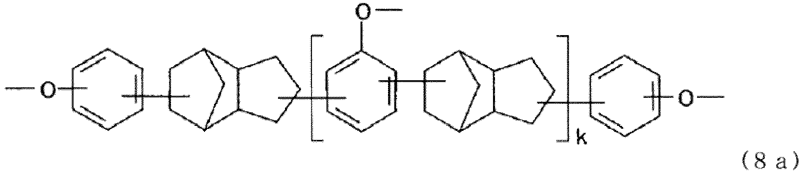
wherein k is 0 or 1;
the aromatic polyvalent carboxylic acid residue is a group represented by the formula (8b):

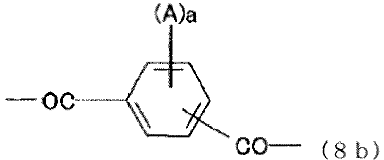

wherein A is the same or different, and is C₁, C₂, C₃, or C₄ alkyl group, a C₁, C₂, C₃, or C₄ alkoxy group, or a halogen atom; and a is 0, 1, 2, 3, or 4; and
the aryloxycarbonyl group is a group represented by the formula (8c-1) :

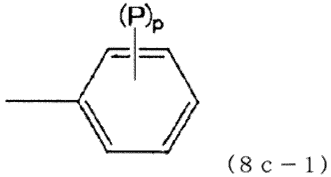

wherein P is the same or different, and is a C₁, C₂, C₃, or C₄ alkyl group, a C₁, C₂, C₃, or C₄ alkoxy group, a nitro group, or a halogen atom; and p is 0, 1, 2, 3, 4, or 5; or
a group represented by the formula (8c-2):

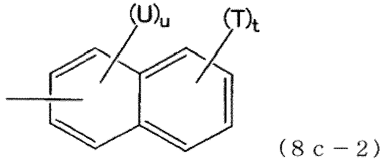

wherein U and T are the same or different, and each is a C₁, C₂, C₃, or C₄ alkyl group, a C₁, C₂, C₃, or C₄ alkoxy group, a nitro group, or a halogen atom; u is 0, 1, 2, or 3; and t is 0, 1, 2, 3, or 4; or
a group represented by the formula (8c-3): 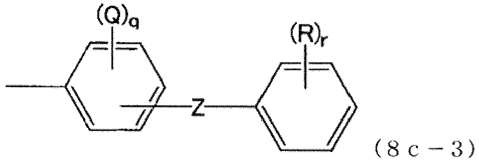
wherein Q and R are the same or different, and each is a C₁, C₂, C₃, or C₄ alkyl group, a C₁, C₂, C₃, or C₄ alkoxy group, a nitro group, or a halogen atom; q is 0, 1, 2, 3, or 4; r is 0, 1, 2, 3, 4, or 5; and Z is a single bond, -0-, -CO-, -CH₂-, -C(CH₃)₂-, or - SO₂⁻.

Examples of the C₁, C₂, C₃, or C₄ alkyl group include a methyl group, an ethyl group, an n-propyl group, an isopropyl group, an n-butyl group, an isobutyl group, and a t-butyl group. Examples of the C₁, C₂, C₃, or C₄ alkoxy group include a methoxy group, an ethoxy group, an n-propoxy group, an isopropoxy group, an n-butoxy group, an isobutoxy group, and a t-butoxy group.

Particularly preferable examples of such polyesters include polyesters obtained by reaction of at least one acid halide of aromatic polyvalent carboxylic acid, at least one aromatic monohydroxy compound, and an aromatic polyvalent hydroxy compound (dicyclopentadienyl diphenol), which are shown in Table 1 below.

**Table 1**

| Acid halide of aromatic polyvalent carboxylic acid | Isophthalic acid chloride Terephthalic acid chloride |
|---|---|
| Aromatic monohydroxy compound | ○-Phenylphenol |
| | α-Naphthol |
| Aromatic polyvalent hydroxy compound | Dicyclopentadienyl diphenol |

The active ester compounds can be used singly or in combination of two or more.

A commercially available ester compound can also be used as the active ester compound in the present invention. As such commercially available ester compounds, ester compounds containing a dicyclopentadienyl diphenol structure, acetylated phenol novolac, benzoylated phenol novolac, etc., are preferable; of these, ester compounds containing a dicyclopentadienyl diphenol structure are more preferable.

More specifically, examples of the ester compound containing a dicyclopentadienyl diphenol structure include EXB9451, EXB9460, EXB9460S-65T, and HPC-8000-65T (produced by DIC, active group equivalent: about 223); examples of the acetylated phenol novolac include DC808 (produced by Mitsubishi Chemical Corp., active group equivalent: about 149); examples of the benzoylated phenol novolac include YLH1026 (produced by Mitsubishi Chemical Corp., active group equivalent: about 200), YLH1030 (produced by Mitsubishi Chemical Corp., active group equivalent: about 201), and YLH1048 (produced by Mitsubishi Chemical Corp., active group equivalent: about 245); and the like.

Commercial products of the active ester compound represented by the formula (7) include HPC-8000-65T (produced by DIC, ester equivalent: about 223 g/eq) and the like. HPC-8000-65T is known to cure an epoxy resin by the following reaction (in the following formula, HPC-8000-65T is represented by R''-CO-O-R''').

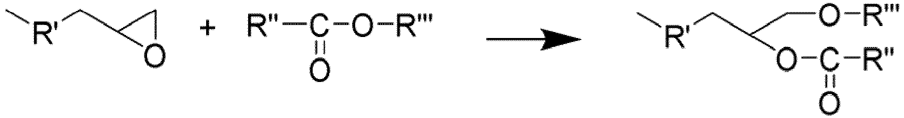

The mixing ratio of the active ester compound in the epoxy resin composition of the present invention is not particularly limited within a range in which the effects of the present invention can be exhibited.

As the mixing ratio of the epoxy resin to the active ester compound, for example, the equivalent ratio of epoxy groups in the epoxy resin to ester groups in the active ester compound (epoxy groups/ester groups) is preferably 0.2 to 3, more preferably 0.5 to 1.5, and even more preferably 0.8 to 1.2. When the equivalent ratio is 3 or less, dielectric characteristics can be further improved. When the equivalent ratio is 0.2 or more, heat resistance is preferably improved.

Although it depends on the equivalent ratio of epoxy groups in the epoxy resin to ester groups in the active ester compound (epoxy groups/ester groups), the active ester compound can be mixed in an amount of, for example, preferably 50 to 200 parts by mass, more preferably 75 to 175 parts by mass, and even more preferably 80 to 150 parts by mass, based on 100 parts by mass of the epoxy resin in the epoxy resin composition.

In the epoxy resin composition of the present invention, the epoxy resin represented by the formula (1) can be used singly or in combination of two or more. Moreover, the active ester compound can also be used singly or in combination of two or more, as described above.

The epoxy resin composition of the present invention may further contain a curing catalyst. The curing catalyst is not particularly limited, as long as it promotes the crosslinking reaction of the epoxy resin represented by the formula (1), or promotes the crosslinking reaction of the epoxy resin represented by the formula (1) with an active ester compound.

Examples of curing catalysts include imidazole compounds, dicyandiamide, tertiary amines, phosphorus-based compounds, Lewis acid compounds, cationic polymerization initiators, and the like.

The epoxy resin composition of the present invention may contain an epoxy resin other than the epoxy resin represented by the formula (1) within a range that does not impair the effects of the present invention. Examples of other epoxy resins include bisphenol A epoxy resins, bisphenol F epoxy resins, phenol novolak epoxy resins, cresol novolak epoxy resins, cycloaliphatic epoxy resins, brominated epoxy resins, triglycidyl isocyanurate, hydrogenated bisphenol A epoxy resins, aliphatic epoxy resins, glycidyl ether epoxy resins, bisphenol S epoxy resins, biphenyl epoxy resins, dicyclo epoxy resins, naphthalene epoxy resins, and the like. These epoxy resins may be used singly or in combination of two or more.

When an epoxy resin other than the epoxy resin represented by the formula (1) is mixed, the mixing ratio of the epoxy resin represented by the formula (1) to the epoxy resin other than the epoxy resin represented by the formula (1) is, by mass ratio, for example, 100:0 to 20:80, preferably 100:0 to 30:70, and more preferably 100:0 to 40:60.

The epoxy resin composition of the present invention may contain, if necessary, fillers, curing agents, thermoplastic resins, additives, etc., within a range that does not impair the objects and effects of the present invention.

The above fillers can be used singly or in combination of two or more, in consideration of flowability, heat resistance, low thermal expansion properties, mechanical characteristics, hardness, scratch resistance, adhesion, etc., which are required for compositions and cured products. Examples of fillers include inorganic compounds, such as silica (specifically crystalline silica, fused silica, spherical fused silica, etc.), titanium oxide, zirconium oxide, zinc oxide, tin oxide, silicon nitride, silicon carbide, boron nitride, calcium carbonate, calcium silicate, potassium titanate, aluminum nitride, indium oxide, alumina, antimony oxide, cerium oxide, magnesium oxide, iron oxide, and tin-doped indium oxide (ITO). Other examples include metals, such as gold, silver, copper, aluminum, nickel, iron, zinc, and stainless steel. Still other examples include minerals, such as montmorillonite, talc, mica, boehmite, kaolin, smectite, zonolite, vermiculite, and sericite. Examples of other fillers include carbon compounds, such as carbon black, acetylene black, Ketchen black, and carbon nanotubes; metal hydroxides, such as aluminum hydroxide and magnesium hydroxide; various types of glass, such as glass beads, glass flakes, and glass balloons; and the like. The filler may be used in a powder form, or may be used after being dispersed in a resin.

Examples of curing agents include amine-based curing agents, amide-based curing agents, acid anhydride-based curing agents, phenol-based curing agents, mercaptan-based curing agents, isocyanate-based curing agents, cyanate ester-based curing agents, and the like. The curing agents may be used singly or in combination of two or more because they can be properly used corresponding to the required characteristics.

Examples of amine-based curing agents include chain aliphatic amines, such as ethylenediamine, diethylenetriamine, triethylenetetramine, and tetraethylenepentamine; alicyclic amines, such as isophoronediamine, benzenediamine, bis(4-aminocyclohexyl)methane, bis(aminomethyl)cyclohexane, and diaminodicyclohexylmethane; aromatic amines, such as metaphenylenediamine, diaminodiphenylmethane, diethyltoluenediamine, and diaminodiethyldiphenylmethane; secondary and tertiary amines, such as benzyldimethylamine, triethylenediamine, piperidine, 2-(dimethylaminomethyl)phenol, 2,4,6-tris(dimethylaminomethyl)phenol, DBU (1,8-diazabicyclo(5,4,0)-undecene-7), DBN (1,5-diazabicyclo(4,3,0)-nonene-5), and the like.

Examples of amide-based curing agents include dicyandiamide and derivatives thereof, polyamide resins (e.g., polyaminoamide), and the like.

Examples of acid anhydride-based curing agents include aliphatic acid anhydrides, such as maleic anhydride and dodecenylsuccinic anhydride; aromatic acid anhydrides, such as phthalic anhydride, trimellitic anhydride, and pyromellitic dianhydride; alicyclic acid anhydrides, such as methylnadic anhydride, tetrahydrophthalic anhydride, methyltetrahydrophthalic anhydride, hexahydrophthalic anhydride, and 4-methylhexahydrophthalic anhydride; and the like.

Examples of phenol-based curing agents include phenol novolak resins, cresol novolak resins, biphenyl-type novolak resins, triphenylmethane-type phenol resins, naphthol novolak resins, phenol biphenylene resins, phenol aralkyl resins, biphenylaralkyl phenol resins, modified polyphenylene ether resins, compounds having a benzoxazine ring, and the like.

Examples of mercaptan-based curing agents include trimethylolpropane tris(3-mercaptopropionate), tris-[(3-mercaptopropionyloxy)-ethyl]-isocyanurate, pentaerythritol tetrakis(3-mercaptopropionate), tetraethyleneglycol bis(3-mercaptopropionate), pentaerythritol tetrakis(3-mercaptobutyrate), 1,4-bis(3-mercaptobutyryloxy)butane, trimethylolpropane tris(3-mercaptobutyrate), trimethylolethane tris(3-mercaptobutyrate), polysulfide polymers, and the like.

Examples of isocyanate-based curing agents include hexamethylene diisocyanate, 1,4-tetramethylene diisocyanate, 2-methylpentane-1,5-diisocyanate, lysine diisocyanate, isophorone diisocyanate, norbornane diisocyanate, and the like.

Examples of thermoplastic resins include polyolefin resins, acrylic resins, phenoxy resins, polyamide resins, polyester resins, polycarbonate resins, polyurethane resins, polyarylate resins, polyphenylene ether resins, polyacetal resins, acid-modified products thereof, and the like. In terms of compatibility with the epoxy resin composition of the present invention and heat resistance, polyolefin resins, acrylic resins, phenoxy resins, polyarylate resins, polyphenylene ether resins, and acid-modified products thereof are preferable; and more preferable among these are polyolefin resins and acid-modified polyolefin resins.

Examples of additives include antioxidants, inorganic fluorescent substances, lubricants, ultraviolet absorbers, heat light stabilizers, antistatic agents, polymerization inhibitors, antifoaming agents, solvents, anti-aging agents, radical inhibitors, adhesion-improving agents, flame retardants, surfactants, storage stability-improving agents, ozone aging inhibitors, thickeners, plasticizers, radiation-blocking agents, nucleating agents, coupling agents, conductivity-imparting agents, phosphorus-based peroxide-decomposing agents, pigments, metal deactivators, physical property-controlling agents, and the like.

The epoxy resin composition of the present invention can be produced by mixing the epoxy resin represented by the formula (1) and an active ester compound, and further optionally other components. The mixing method is not particularly limited, as long as it allows uniform mixing. The epoxy resin composition of the present invention may contain, if necessary, a solvent (e.g., toluene, xylene, methyl ethyl ketone, acetone, cyclohexanone, methylcyclohexane, or cyclohexane) within a range that does not adversely affect the effects of the present invention.

A cured product can be obtained by curing the epoxy resin composition of the present invention (i.e., a cured product of the epoxy resin composition). The curing method is not particularly limited. For example, the composition can be cured by heating. The curing temperature is generally room temperature to 300°C. The curing time varies depending on the composition liquid, and can be generally widely set from 30 minutes to 1 week.

In the present specification, the term "comprising" includes "consisting essentially of" and "consisting of."

### Examples

The present invention is described in more detail below; however, the present invention is not limited to the following examples.

### Production Example 1 (Production of Epoxy Resin A)

Allyl glycidyl ether (5.9 g), 0.05 g of 2 wt% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 4 hours. After the toluene was removed by concentration, 10.3 g (epoxy equivalent: 211 g/eq) of 1,4-bis[(2,3-epoxypropyloxypropyl)dimethylsilyl]benzene (epoxy resin A) was obtained as a colorless, transparent liquid.

### Production Example 2 (Production of Epoxy Resin B)

1,2-Epoxy-5-hexene (5.0 g), 0.05 g of 2 wt% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 5 hours. After the toluene was removed by concentration, 9.5 g (epoxy equivalent: 195 g/eq) of 1,4-bis[(2,3-epoxybutyl)dimethylsilyl]benzene (epoxy resin B) was obtained as a colorless, transparent liquid.

### Production Example 3 (Production of Epoxy Resin C)

1,2-Epoxy-4-vinylcyclohexane (6.4 g), 0.05 g of 2 wt% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 4 hours. After the toluene was removed by concentration, 10.8 g (epoxy equivalent: 221 g/eq) of 1,4-bis{[2-(3,4-epoxycyclohexyl)ethyl]dimethylsilyl}benzene (epoxy resin C) was obtained as a colorless, transparent liquid.

### Production Example 4 (Production of Epoxy Resin D)

1,2-Epoxy-4-vinylcyclohexane (4.3 g), 0.05 g of 2 wt% ethanol solution of hexachloroplatinic acid hexahydrate, and 250 g of toluene were placed in a 200-mL four-necked flask equipped with a stirrer, a thermometer, and a condenser in a nitrogen atmosphere, and the liquid temperature was raised to 70°C. Thereafter, 5.0 g of bis[(p-dimethylsilyl)phenyl]ether was added dropwise for 15 minutes, and the mixture was then stirred at 90°C for 6 hours. After the toluene was removed by concentration, 8.9 g (epoxy equivalent: 267 g/eq) of 4,4'-bis{[2-(3,4-epoxycyclohexyl)ethyl]dimethylsilyl}diphenyl ether (epoxy resin D) was obtained as a colorless, transparent liquid.

### Production Example 5 (Production of Epoxy Resin E)

1,2-Epoxy-4-vinylcyclohexane (7.4 g), 0.05 g of 2 wt% ethanol solution of hexachloroplatinic acid hexahydrate, and 250 g of toluene were placed in a 200-mL four-necked flask equipped with a stirrer, a thermometer, and a condenser in a nitrogen atmosphere, and the liquid temperature was raised to 70°C. Thereafter, 5.0 g of 1,3,5-tris(dimethylsilyl)benzene was added dropwise for 15 minutes, and the mixture was then stirred at 90°C for 6 hours. After the toluene was removed by concentration, 11.8 g (epoxy equivalent: 208 g/eq) of 1,3,5-tris{[2-(3,4-epoxycyclohexyl)ethyl]dimethylsilyl}benzene (epoxy resin E) was obtained as a colorless, transparent liquid.

### Examples and Comparative Examples

Components in amounts shown in Tables 2 and 3 were each weighed in an eggplant flask and stirred with a magnetic stirrer at room temperature (25°C) for 5 minutes. Thereafter, toluene (a solvent of an active ester compound) was distilled off under reduced pressure while heating at 60°C, thereby preparing epoxy resin compositions.

The components in Tables 2 and 3 are as follows. The numerical value of each component in Tables 2 and 3 represents part by mass.
- Epoxy resin F: Bis-A epoxy resin (Grade 828), produced by Mitsubishi Chemical Corporation (epoxy equivalent: 189 g/eq)
- Epoxy resin G: cycloaliphatic epoxy resin, produced by Daicel Corporation (Celloxide 2021P; general name: 3',4'-epoxycyclohexylmethyl 3,4-epoxycyclohexanecarboxylate) (epoxy equivalent: 137 g/eq)
- Active ester compound: active ester resin EPICLON HPC-8000-65T, produced by DIC (a toluene solution, solids concentration: 65%, ester equivalent: about 223 g/eq)
- Curing catalyst: 4-dimethylaminopyridine (DMAP), produced by Tokyo Chemical Industry Co., Ltd.

The obtained epoxy resin compositions of the Examples and Comparative Examples were evaluated for the following items. Tables 2 and 3 also show the results of each evaluation.

### (1) Heat Resistance (Glass Transition Temperature)

The epoxy resin compositions obtained in the Examples and Comparative Examples were each poured into a mold, and cured by heating at 100°C for 1 hour, 120°C for 2 hours, and 150°C for 2 hours. The glass transition temperature of the obtained test pieces was measured using a thermomechanical analyzer (SSC5200, produced by SII NanoTechnology Inc.) in compression mode at a load of 50 mN at 5°C/min.

### (2) 90-Degree Peel Strength against Copper Foil

The epoxy resin compositions obtained in the Examples and Comparative Examples were each applied to an aluminum plate, and a 35-µm-thick electrolytic copper foil (produced by Furukawa Electric Co., Ltd.) was superimposed thereon. The resulting products were cured by heating at 100°C for 1 hour, 120°C for 2 hours, and 150°C for 2 hours. After curing, cuts with a width of 1 cm were made with a cutter on the cured products, thereby preparing 90-degree peel strength test pieces. The obtained test pieces were each subjected to a 90-degree peel strength test using AGS-X (produced by Shimadzu Corp.) at a test rate of 50 mm/min.

### (3) Electric Characteristics (Dielectric Loss Tangent)

The epoxy resin compositions obtained in the Examples and Comparative Examples were each poured into a resin mold (thickness: 2 mm), and cured by heating at 100°C for 1 hour, 120°C for 2 hours, and 150°C for 2 hours. Subsequently, the cured products were each cut into size of 20 mm width x 30 mm length x 2 mm thickness. Thus, test pieces were obtained. The dielectric loss tangent (1 GHz) of each of the obtained test pieces was measured using a dielectric constant measuring device (Impedance Analyzer, produced by Agilent) at 25°C. The dielectric constant measuring device was calibrated with PTFE.

**Table 2**

| | | Example | | | | | |
|---|---|---|---|---|---|---|---|
| | | 1 | 2 | 3 | 4 | 5 | 6 |
| Epoxy resin | Epoxy resin A | 100 | | | | | |
| | Epoxy resin B | | 100 | | | | |
| | Epoxy resin C | | | 100 | 50 | | |
| | Epoxy resin D | | | | | 100 | |
| | Epoxy resin E | | | | | | 100 |
| | Epoxy resin F | | | | 50 | | |
| Active ester compound (65% toluene solution) | | 160 | 160 | 155 | 168 | 128 | 165 |
| (Epoxy group/ester group) equivalent ratio | | 1.0 | 1.1 | 1.0 | 1.1 | 1.0 | 1.0 |
| Curing catalyst | | 1 | 1 | 1 | 1 | 1 | 1 |
| Heat resistance (glass transition temperature: °C) | | 150 | 150 | 160 | 155 | 155 | 170 |
| Copper foil peel strength (N/cm) | | 8 | 8 | 7 | 7 | 8 | 7 |
| Dielectric loss tangent (1 GHz) | | 0.004 | 0.003 | 0.003 | 0.004 | 0.003 | 0.003 |

**Table 3**

| | | Comparative Example | |
|---|---|---|---|
| | | 1 | 2 |
| Epoxy resin | Epoxy resin F | 100 | |
| | Epoxy resin G | | 100 |
| Active ester compound (65% toluene solution) | | 181 | 251 |
| (Epoxy group/ester group) equivalent ratio | | 1.0 | 1.0 |
| Curing catalyst | | 1 | 1 |
| Heat resistance (glass transition temperature: °C) | | 150 | 150 |
| Copper foil peel strength (N/cm) | | 6 | 6 |
| Dielectric loss tangent (1 GHz) | | 0.010 | 0.010 |

## Claims

1. An epoxy resin composition comprising an epoxy resin and an active ester compound, the epoxy resin being represented by the formula (1): 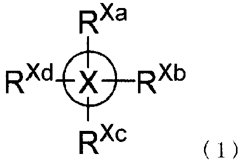
wherein X ring is a saturated hydrocarbon ring or an unsaturated hydrocarbon ring, or rings having a structure in which 2 to 6 saturated hydrocarbon rings and/or unsaturated hydrocarbon rings are condensed, or in which 2 saturated hydrocarbon rings and/or unsaturated hydrocarbon rings are connected;
R^{Xa}, R^{Xb}, R^{Xc}, and R^{Xd} are the same or different, and each is a hydrogen atom, a lower alkyl group, a lower alkoxy group, a lower alkenyl group, a halogen atom, or a group represented by the formula (3): 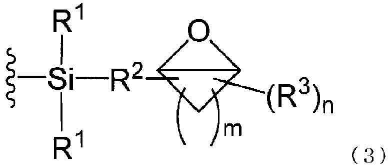
wherein R¹ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
R² is a C₁₋₁₈ alkylene group, wherein one or more carbon atoms of this group other than a carbon atom directly bonded to a silicon atom may be replaced by at least one atom selected from the group consisting of an oxygen atom and a nitrogen atom;
R³ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
m is an integer of 0 to 6; and
n is an integer of 0 to 3;
provided that at least one of R^{Xa}, R^{Xb}, R^{Xc}, and R^{Xd} is a group represented by the formula (3); and
one or more hydrogen atoms bonded to one or more carbon atoms that constitute the hydrocarbon ring constituting the X ring, and that are not bonded to R^{Xa}, R^{Xb}, R^{Xc}, or R^{Xd}, may be replaced by a lower alkyl group, a lower alkoxy group, a lower alkenyl group, or a halogen atom.

2. The epoxy resin composition according to claim 1,
wherein the rings having a structure in which 2 saturated hydrocarbon rings and/or unsaturated hydrocarbon rings are connected are rings represented by the formula (2): 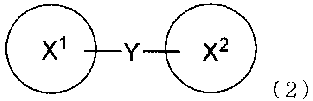
wherein X¹ ring and X² ring are the same or different, and each is a saturated hydrocarbon ring or an unsaturated hydrocarbon ring; and
Y is a bond, a C₁₋₆ alkylene group that may be substituted with a C₁₋₄ alkyl group, an oxygen atom (-0-), a sulfur atom (-S-), -SO-, or -SO₂-.

3. The epoxy resin composition according to claim 1 or 2, wherein the saturated hydrocarbon ring is a C₄₋₈ saturated hydrocarbon ring, and the unsaturated hydrocarbon ring is a C₄₋₈ unsaturated hydrocarbon ring.

4. The epoxy resin composition according to claim 1,
wherein the composition comprises an active ester compound and at least one epoxy resin selected from the group consisting of: an epoxy resin represented by the formula (1-iia): 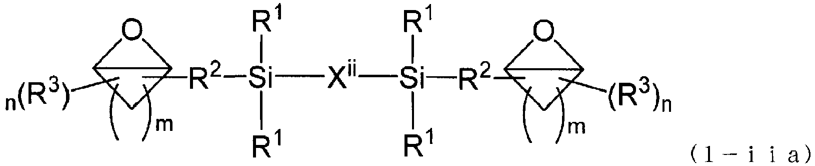 wherein Xⁱⁱ is a divalent group obtained by removing two hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a divalent group represented by the formula (2^{g}-iia): 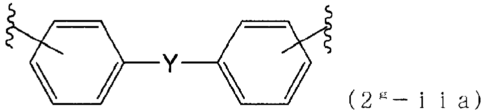
wherein Y is a bond, a C₁₋₆ alkylene group that may be substituted with a C₁₋₄ alkyl group, an oxygen atom (-O-), a sulfur atom (-S-), -SO-, or -SO₂-;
R¹ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
R² is the same or different, and is a C₁₋₁₈ alkylene group, wherein one or more carbon atoms of this group other than a carbon atom directly bonded to a silicon atom may be replaced by at least one atom selected from the group consisting of an oxygen atom and a nitrogen atom;
R³ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
m is an integer of 0 to 6; and
n is an integer of 0 to 3; and
an epoxy resin represented by the formula (1-iiia): 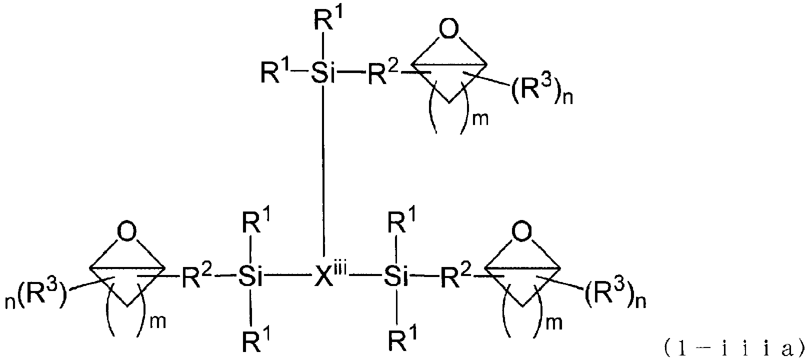
wherein Xⁱⁱⁱ is a trivalent group obtained by removing three hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a trivalent group represented by the formula (2^{g}-iiia): 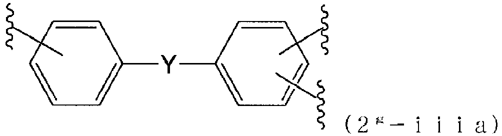
wherein Y is as defined above; and
R¹, R², R³, m, and n are as defined above.

5. The epoxy resin composition according to any one of claims 1 to 4, wherein the active ester compound is a compound having two or more ester groups per molecule.

6. The epoxy resin composition according to any one of claims 1 to 4, wherein the active ester compound is a condensate of at least one member selected from the group consisting of a carboxylic acid compound and a thiocarboxylic acid compound, and at least one member selected from the group consisting of a hydroxy compound and a thiol compound.

7. The epoxy resin composition according to any one of claims 1 to 4, wherein the active ester compound is an ester compound containing a dicyclopentadienyl diphenol structure.

8. A cured product of the epoxy resin composition according to any one of claims 1 to 7.

9. A semiconductor sealing material, a liquid sealing material, a potting material, a sealing material, an interlayer insulation film, an adhesive layer, a coverlay film, an electromagnetic shielding film, a printed circuit board material, or a composite material, each of which uses the epoxy resin composition according to any one of claims 1 to 7 or the cured product according to claim 8.

## Patentansprüche

1. Epoxidharz-Zusammensetzung, die ein Epoxidharz und eine aktive Esterverbindung umfasst, wobei das Epoxidharz durch die Formel (1) dargestellt ist: 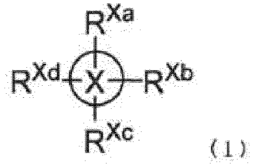
worin der Ring X ein gesättigter Kohlenwasserstoffring oder ein ungesättigter Kohlenwasserstoffring oder Ringe mit einer Struktur sind, bei der 2 bis 6 gesättigte Kohlenwasserstoffringe und/oder ungesättigte Kohlenwasserstoffringe kondensiert sind oder bei der 2 gesättigte Kohlenwasserstoffringe und/oder ungesättigte Kohlenwasserstoffringe verbunden sind;
R^{Xa}, R^{Xb}, R^{Xc} und R^{Xd} gleich oder unterschiedlich sind und jeweils ein Wasserstoffatom, eine Niederalkylgruppe, eine Niederalkoxygruppe, eine Niederalkenylgruppe, ein Halogenatom oder eine Gruppe der Formel (3) sind: 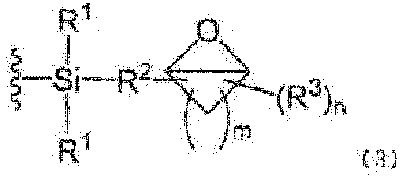
worin die R¹ gleich oder unterschiedlich jeweils und eine C₁₋₁₈-Alkylgruppe, eine C₂₋₉-Alkenylgruppe, eine Cycloalkylgruppe, eine Arylgruppe oder eine Aralkylgruppe sind, wobei gegebenenfalls ein oder mehrere Kohlenstoffatome dieser Gruppen durch zumindest ein aus der aus einem Sauerstoffatom und einem Stickstoffatom bestehenden Gruppe ausgewähltes Atom ersetzt sind;
R² eine C₁₋₁₈-Alkylengruppe ist, wobei gegebenenfalls ein oder mehrere Kohlenstoffatome dieser Gruppe, mit Ausnahme eines Kohlenstoffatoms, das direkt an ein Siliciumatom gebunden ist, durch zumindest ein aus der aus einem Sauerstoffatom und einem Stickstoffatom bestehenden Gruppe ausgewähltes Atom ersetzt sind;
die R³ gleich oder unterschiedlich und jeweils eine C₁₋₁₈-Alkylgruppe, eine C₂₋₉-Alkenylgruppe, eine Cycloalkylgruppe, eine Arylgruppe oder eine Aralkylgruppe sind, wobei gegebenenfalls ein oder mehrere Kohlenstoffatome dieser Gruppen durch zumindest ein aus der aus einem Sauerstoffatom und einem Stickstoffatom bestehenden Gruppe ausgewähltes Atom ersetzt sind;
m eine ganze Zahl von 0 bis 6 ist; und
n eine ganze Zahl von 0 bis 3 ist;
mit der Maßgabe, dass zumindest einer von R^{Xa}, R^{Xb}, R^{Xc} und R^{Xd} eine Gruppe der Formel (3) ist; und
gegebenenfalls ein oder mehrere Wasserstoffatome, die an ein oder mehrere Kohlenstoffatome gebunden sind, die den Kohlenwasserstoffring bilden, der den X-Ring bildet, und die nicht an R^{Xa}, R^{Xb}, R^{Xc} oder R^{Xd} gebunden sind, durch eine Niederalkylgruppe, eine Niederalkoxygruppe, eine Niederalkenylgruppe oder ein Halogenatom ersetzt sind.

2. Epoxidharz-Zusammensetzung nach Anspruch 1, wobei die Ringe mit einee Struktur, bei der 2 gesättigte Kohlenwasserstoffringe und/oder ungesättigte Kohlenwasserstoffringe verbunden sind, Ringe der Formel (2) sind: 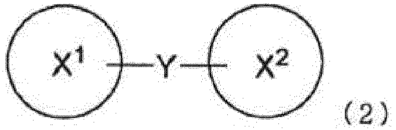
worin der Ring X¹ und der Ring X² gleich oder unterschiedlich sind und jeweils ein gesättigter Kohlenwasserstoffring oder ein ungesättigter Kohlenwasserstoffring sind; und
Y eine Bindung, eine C₁₋₆-Alkylengruppe, die gegebenenfalls mit einer C₁₋₄-Alkylgruppe substituiert ist, ein Sauerstoffatom (-O-), ein Schwefelatom (-S-), -SO- oder -SO₂- ist.

3. Epoxidharz-Zusammensetzung nach Anspruch 1 oder 2, wobei der gesättigte Kohlenwasserstoffring ein gesättigter C₄₋₈-Kohlenwasserstoffring ist und der ungesättigte Kohlenwasserstoffring ein ungesättigter C₄₋₈-Kohlenwasserstoffring ist.

4. Epoxidharz-Zusammensetzung nach Anspruch 1, wobei die Zusammensetzung eine aktive Esterverbindung und zumindest ein Epoxidharz umfasst, das aus der aus Folgendem bestehenden Gruppe ausgewählt ist:
- einem Epoxidharz der Formel (1-iia): 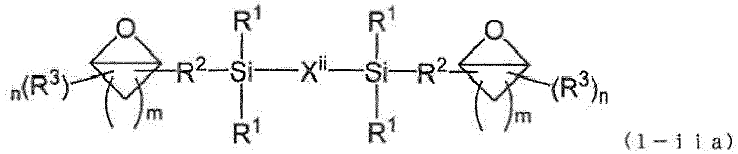 worin Xⁱⁱ eine zweiwertige Gruppe, die durch Entfernen von zwei Wasserstoffatomen von einem gesättigten Kohlenwasserstoffring oder einem ungesättigten Kohlenwasserstoffring oder von Ringen mit einer Struktur, bei der 2 bis 6 gesättigte Kohlenwasserstoffringe und/oder ungesättigte Kohlenwasserstoffringe kondensiert sind, erhalten wird; oder eine zweiwertige Gruppe der Formel (2^{g}-iia) ist: 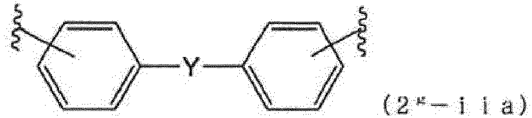
worin Y eine Bindung, eine C₁₋₆-Alkylengruppe, die gegebenenfalls mit einer C₁₋₄-Alkylgruppe substituiert ist, ein Sauerstoffatom (-O-), ein Schwefelatom (-S-), -SO- oder -SO₂- ist;
die R¹ gleich oder unterschiedlich und jeweils eine C₁₋₁₈-Alkylgruppe, eine C₂₋₉-Alkenylgruppe, eine Cycloalkylgruppe, eine Arylgruppe oder eine Aralkylgruppe sind, wobei gegebenenfalls ein oder mehrere Kohlenstoffatome dieser Gruppen durch zumindest ein aus der aus einem Sauerstoffatom und einem Stickstoffatom bestehenden Gruppe ausgewähltes Atom ersetzt sind;
die R² gleich oder unterschiedlich und jeweils eine C₁₋₁₈-Alkylengruppe sind, wobei gegebenenfalls ein oder mehrere Kohlenstoffatome dieser Gruppe, mit Ausnahme eines Kohlenstoffatoms, das direkt an ein Siliciumatom gebunden ist, durch zumindest ein aus der aus einem Sauerstoffatom und einem Stickstoffatom bestehenden Gruppe ausgewähltes Atom ersetzt sind;
die R³ gleich oder unterschiedlich und jeweils eine C₁₋₁₈-Alkylgruppe, eine C₂₋₉-Alkenylgruppe, eine Cycloalkylgruppe, eine Arylgruppe oder eine Aralkylgruppe sind, wobei gegebenenfalls ein oder mehrere Kohlenstoffatome dieser Gruppen durch zumindest ein aus der aus einem Sauerstoffatom und einem Stickstoffatom bestehenden Gruppe ausgewähltes Atom ersetzt sind;
m eine ganze Zahl von 0 bis 6 ist; und
n eine ganze Zahl von 0 bis 3 ist; und
- einem Epoxidharz der Formel (1-iiia): 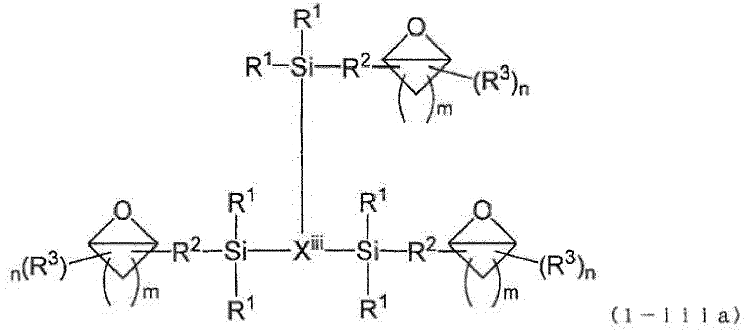 worin Xⁱⁱⁱ eine dreiwertige Gruppe, die durch Entfernen von drei Wasserstoffatomen von einem gesättigten Kohlenwasserstoffring oder einem ungesättigten Kohlenwasserstoffring oder von Ringen mit einer Struktur, bei der 2 bis 6 gesättigte Kohlenwasserstoffringe und/oder ungesättigte Kohlenwasserstoffringe kondensiert sind, erhalten wird; oder eine dreiwertige Gruppe der Formel (2^{g}-iiia) ist: 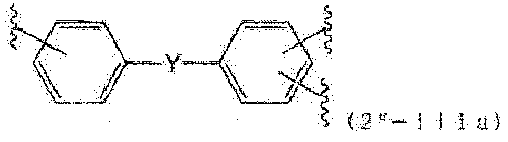
worin Y wie vorstehend definiert ist; und
R¹, R², R³, m und n wie vorstehend definiert sind.

5. Epoxidharz-Zusammensetzung nach einem der Ansprüche 1 bis 4, wobei die aktive Esterverbindung eine Verbindung mit zwei oder mehr Estergruppen pro Molekül ist.

6. Epoxidharz-Zusammensetzung nach einem der Ansprüche 1 bis 4, wobei die aktive Esterverbindung ein Kondensat aus zumindest einem aus der aus einer Carbonsäureverbindung und einer Thiocarbonsäureverbindung bestehenden Gruppe ausgewählten Element und zumindest einem aus der aus einer Hydroxyverbindung und einer Thiolverbindung bestehenden Gruppe ausgewählten Element darstellt.

7. Epoxidharz-Zusammensetzung nach einem der Ansprüche 1 bis 4, wobei die aktive Esterverbindung eine Esterverbindung mit Dicyclopentadienyldiphenol-Struktur darstellt.

8. Gehärtetes Produkt aus einer Epoxidharz-Zusammensetzung nach einem der Ansprüche 1 bis 7.

9. Halbleiterversiegelungsmaterial, flüssiges Versiegelungsmaterial, Vergussmaterial, Versiegelungsmaterial, Zwischenschicht-Isolierfolie, Klebeschicht, Deckschichtfolie, elektromagnetische Abschirmfolie, Leiterplattenmaterial oder Verbundwerkstoff, in dem oder der jeweils eine Epoxidharz-Zusammensetzung nach einem der Ansprüche 1 bis 7 oder ein gehärtetes Produkt nach Anspruch 8 zum Einsatz kommt.

## Revendications

1. Composition de résine époxy comprenant une résine époxy et un composé ester actif, la résine époxy étant représentée par la formule (1) : 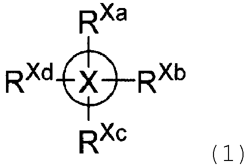
dans laquelle le cycle X est un cycle hydrocarboné saturé ou un cycle hydrocarboné insaturé, ou des cycles ayant une structure dans laquelle 2 à 6 cycles hydrocarbonés saturés et/ou cycles hydrocarbonés insaturés sont condensés, ou dans laquelle 2 cycles hydrocarbonés saturés et/ou cycles hydrocarbonés insaturés sont reliés ;
R^{Xa}, R^{Xb}, R^{Xc} et R^{Xd} sont identiques ou différents, et chacun est un atome d'hydrogène, un groupe alkyle inférieur, un groupe alcoxy inférieur, un groupe alcényle inférieur, un atome d'halogène ou un groupe représenté par la formule (3) : 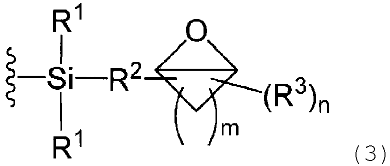
dans laquelle R¹ est identique ou différent, et est un groupe alkyle en C₁₋₁₈, un groupe alcényle en C₂₋₉, un groupe cycloalkyle, un groupe aryle ou un groupe aralkyle, dans laquelle un ou plusieurs atomes de carbone de ces groupes peuvent être remplacés par au moins un atome choisi dans le groupe constitué d'un atome d'oxygène et d'un atome d'azote ;
R² est un groupe alkylène en C₁₋₁₈, dans laquelle un ou plusieurs atomes de carbone de ce groupe autres qu'un atome de carbone directement lié à un atome de silicium peuvent être remplacés par au moins un atome choisi dans le groupe constitué d'un atome d'oxygène et d'un atome d'azote ;
R³ est identique ou différent, et est un groupe alkyle en C₁₋₁₈, un groupe alcényle en C₂₋₉, un groupe cycloalkyle, un groupe aryle ou un groupe aralkyle, dans laquelle un ou plusieurs atomes de carbone de ces groupes peuvent être remplacés par au moins un atome choisi dans le groupe constitué d'un atome d'oxygène et d'un atome d'azote ;
m est un entier de 0 à 6 ; et
n est un entier de 0 à 3 ;
à condition qu'au moins l'un de R^{Xa}, R^{Xb}, R^{Xc} et R^{Xd} est un groupe représenté par la formule (3) ; et
un ou plusieurs atomes d'hydrogène liés à un ou plusieurs atomes de carbone qui constituent le cycle hydrocarboné constituant le cycle X, et qui ne sont pas liés à R^{Xa}, R^{Xb}, R^{Xc} ou R^{Xd}, peuvent être remplacés par un groupe alkyle inférieur, un groupe alcoxy inférieur, un groupe alcényle inférieur ou un atome d'halogène.

2. Composition de résine époxy selon la revendication 1, dans laquelle les cycles ayant une structure dans laquelle 2 cycles hydrocarbonés saturés et/ou cycles hydrocarbonés insaturés sont reliés sont des cycles représentés par la formule (2) : 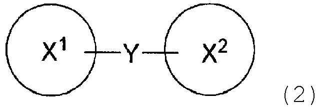
dans laquelle le cycle X¹ et le cycle X² sont identiques ou différents, et chacun est un cycle hydrocarboné saturé ou un cycle hydrocarboné insaturé ; et
Y est une liaison, un groupe alkylène en C₁-₆ qui peut être substitué par un groupe alkyle en C₁₋₄, un atome d'oxygène (-O-), un atome de soufre (-S-), -SO- ou -SO₂-.

3. Composition de résine époxy selon la revendication 1 ou 2, dans laquelle le cycle hydrocarboné saturé est un cycle hydrocarboné saturé en C₄₋₈, et le cycle hydrocarboné insaturé est un cycle hydrocarboné insaturé en C₄₋₈.

4. Composition de résine époxy selon la revendication 1, où la composition comprend un composé ester actif et au moins une résine époxy choisie dans le groupe constitué de :
une résine époxy représentée par la formule (1-iia) : 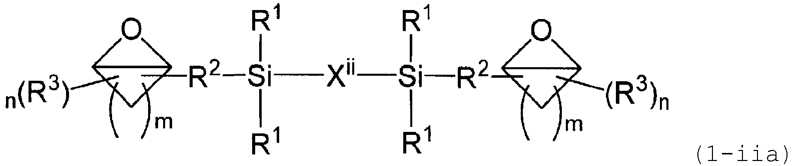 dans laquelle Xⁱⁱ est un groupe divalent obtenu par élimination de deux atomes d'hydrogène d'un cycle hydrocarboné saturé ou d'un cycle hydrocarboné insaturé, ou de cycles ayant une structure dans laquelle 2 à 6 cycles hydrocarbonés saturés et/ou cycles hydrocarbonés insaturés sont condensés ; ou un groupe divalent représenté par la formule (2^{g}-iia) : 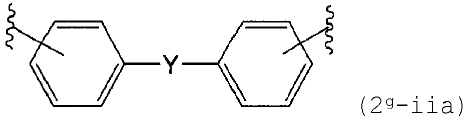
dans laquelle Y est une liaison, un groupe alkylène en C₁₋₆ qui peut être substitué par un groupe alkyle en C₁₋₄, un atome d'oxygène (-O-) , un atome de soufre (-S-), -SO-, ou -SO₂- ;
R¹ est identique ou différent, et est un groupe alkyle en C₁₋₁₈, un groupe alcényle en C₂₋₉, un groupe cycloalkyle, un groupe aryle ou un groupe aralkyle, dans laquelle un ou plusieurs atomes de carbone de ces groupes peuvent être remplacés par au moins un atome choisi dans le groupe constitué d'un atome d'oxygène et d'un atome d'azote ;
R² est identique ou différent, et est un groupe alkylène en C₁₋₁₈, dans laquelle un ou plusieurs atomes de carbone de ce groupe autres qu'un atome de carbone directement lié à un atome de silicium peuvent être remplacés par au moins un atome choisi dans le groupe constitué d'un atome d'oxygène et d'un atome d'azote ;
R³ est identique ou différent, et est un groupe alkyle en C₁₋₁₈, un groupe alcényle en C₂₋₉, un groupe cycloalkyle, un groupe aryle ou un groupe aralkyle, dans laquelle un ou plusieurs atomes de carbone de ces groupes peuvent être remplacés par au moins un atome choisi dans le groupe constitué d'un atome d'oxygène et d'un atome d'azote ;
m est un entier de 0 à 6 ; et
n est un entier de 0 à 3 ; et
une résine époxy représentée par la formule (1-iiia) : 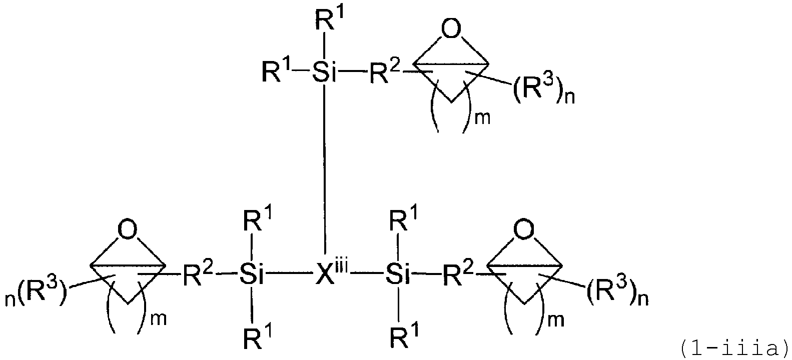
dans laquelle Xⁱⁱⁱ est un groupe trivalent obtenu par élimination de trois atomes d'hydrogène d'un cycle hydrocarboné saturé ou d'un cycle hydrocarboné insaturé, ou de cycles ayant une structure dans laquelle 2 à 6 cycles hydrocarbonés saturés et/ou cycles hydrocarbonés insaturés sont condensés ; ou un groupe trivalent représenté par la formule (2^{g}-iiia) : 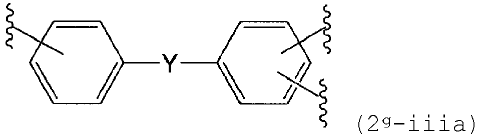
dans laquelle Y est tel que défini ci-dessus ; et
R¹, R², R³, m et n sont tels que définis ci-dessus.

5. Composition de résine époxy selon l'une quelconque des revendications 1 à 4, dans laquelle le composé ester actif est un composé ayant deux ou plus de deux groupes ester par molécule.

6. Composition de résine époxy selon l'une quelconque des revendications 1 à 4, dans laquelle le composé ester actif est un condensat d'au moins un membre choisi dans le groupe constitué d'un composé d'acide carboxylique et d'un composé d'acide thiocarboxylique, et au moins un membre choisi dans le groupe constitué d'un composé hydroxy et d'un composé thiol.

7. Composition de résine époxy selon l'une quelconque des revendications 1 à 4, dans laquelle le composé ester actif est un composé ester contenant une structure de dicyclopentadiényldiphénol.

8. Produit durci de la composition de résine époxy selon l'une quelconque des revendications 1 à 7.

9. Matériau d'étanchéité de semi-conducteur, matériau d'étanchéité aux liquides, matériau d'enrobage, matériau de scellement, film d'isolation de couche intermédiaire, couche d'adhésif, film de couverture, film de blindage électromagnétique, matériau de carte de circuit imprimé ou matériau composite, dont chacun utilise la composition de résine époxy selon l'une quelconque des revendications 1 à 7 ou le produit durci selon la revendication 8.
